# EUROPÄISCHE PATENTSCHRIFT

(11) **EP 4 189 417 B1**
(45) Veröffentlichungstag und Bekanntmachung des Hinweises auf die Patenterteilung: **17.07.2024**
(21) Anmeldenummer: 21754897.3
(22) Anmeldetag: 28.07.2021
(51) Int. Cl.: G01R 35/00

(54) **VERFAHREN ZUR KONTROLLE DER MESSGENAUIGKEIT EINER LADEANSCHLUSSVORRICHTUNG FÜR ELEKTROFAHRZEUGE SOWIE ENTSPRECHENDE LADEANSCHLUSSVORRICHTUNG**
METHOD FOR MONITORING THE MEASURING ACCURACY OF A CHARGING CONNECTION DEVICE FOR ELECTRIC VEHICLES AND CORRESPONDING CHARGING CONNECTION DEVICE
PROCÉDÉ DE SURVEILLANCE DE LA PRÉCISION DE MESURE D'UN DISPOSITIF DE CONNEXION DE CHARGE POUR VÉHICULES ÉLECTRIQUES ET DISPOSITIF DE CONNEXION DE CHARGE CORRESPONDANT

(30) Priorität: 28.07.2020 DE 102020119890
(43) Veröffentlichungstag der Anmeldung: 07.06.2023
(73) Patentinhaber: KEBA Energy Automation GmbH, 4040 Linz (AT)
(72) Erfinder: WEIDINGER, Gerhard, 4614 Marchtrenk (AT); HUG, Markus, 4501 Neuhofen an der Krems (AT)
(74) Vertreter: Burger, Hannes
(86) Internationale Anmeldenummer: PCT/AT2021/060261
(87) Internationale Veröffentlichungsnummer: WO 2022/020872

(56) Entgegenhaltungen:
- WO-A1-2019/067638
- CN-U- 207 198 262
- CN-U- 211 014 495
- DE-A1- 102014 013 870
- US-A1- 2011 279 082
- US-A1- 2018 188 346
- POPOV ANDREY ET AL: "Power hardware-in-the-loop test bench for tests and verification of EV and EVSE charging systems", 2014 IEEE INTERNATIONAL ELECTRIC VEHICLE CONFERENCE (IEVC), IEEE, 17 December 2014 (2014-12-17), pages 1 - 8, XP032744190, DOI: 10.1109/IEVC.2014.7056139
- NOHRER MARTIN ET AL: "Flexible test system architecture for electric vehicle charging infrastructure", 2014 IEEE INTERNATIONAL ELECTRIC VEHICLE CONFERENCE (IEVC), IEEE, 17 December 2014 (2014-12-17), pages 1 - 7, XP032744215, DOI: 10.1109/IEVC.2014.7056147
- SUN YUAN ET AL: "Research on Testing System and Test Method for Charging Facilities of Electric Vehicles", 2018 5TH IEEE INTERNATIONAL CONFERENCE ON CLOUD COMPUTING AND INTELLIGENCE SYSTEMS (CCIS), IEEE, 23 November 2018 (2018-11-23), pages 1048 - 1052, XP033535797, DOI: 10.1109/CCIS.2018.8691342

## Beschreibung

Die Erfindung betrifft ein Verfahren zur Kontrolle der Messgenauigkeit einer Ladeanschlussvorrichtung für Elektrofahrzeuge, sowie eine Ladeanschlussvorrichtung für Elektrofahrzeuge welche eine verbesserte, eichrechtliche Kontrolle der Messgenauigkeit der Ladeanschlussvorrichtung ermöglicht, wie dies in den Ansprüchen angegeben ist.

Vor allem bei Messgeräten, welche in Zusammenhang mit einer verbrauchs- bzw. nutzungsabhängigen Abrechnung von Waren- oder Energiebezügen stehen, ist die Messgenauigkeit von hoher Bedeutung. Die entsprechende Messgenauigkeit der jeweiligen Messgeräte muss dabei auch längerfristig beibehalten werden können und kann daher vor allem bei öffentlichem Interesse einer staatlich regulierten Eichpflicht unterliegen. Vor allem zum Schutz von Konsumenten bzw. Verbrauchern kann es daher staatliche Eichgesetze geben. Diese Eichgesetze können in verschiedenen Ländern oder sogar Regionen unterschiedlich sein, insbesondere hinsichtlich Prüfumfang und wiederkehrendem Prüfintervall.

Neben Wasser- oder Gaszählern unterliegen vor allem auch Energiezähler für die Messung des Stromverbrauches in Wohnanlagen einer Eichpflicht. Je nach Art des Messgerätes wird dabei nach einer gewissen Zeitspanne eine stichprobenartige Anzahl solcher Messgeräte einer Kontrolle bzw. wiederkehrenden Eichung unterworfen. Diese Eichkontrolle erfolgt in der Regel durch anerkannte Prüfstellen, insbesondere durch Eichämter. Solche Eichungen werden für haushaltsübliche Strom- bzw. Elektrizitätszähler seit vielen Jahren praktiziert, wobei mittels standardmäßig vorhandener Eichungskontrollgeräte bzw. Eichungsanlagen überprüft wird, ob die jeweiligen Stromzähler weiterhin zuverlässig bzw. exakt arbeiten und auch nicht manipuliert wurden. Diese standardmäßigen Eichungskontrollgeräte haben sich für die Überprüfung von Haushalts-Stromzählern gut bewährt. Sie sind auch für Ladeanschlussvorrichtungen, bei denen ein baulich eigenständiger Stromzähler eingebaut ist, beispielsweise ein Universal-Stromzähler für die Hutschienenmontage, gut verwendbar. Diese standardmäßigen Eichungskontrollgeräte der Prüfstellen sind jedoch für die Überprüfung von Ladeanschlussvorrichtungen für Elektrofahrzeuge mit integrierten Energiemessvorrichtungen, insbesondere mit elektronisch implementieren Energiemessvorrichtungen, nur bedingt zufriedenstellend. Daher besteht grundsätzlich ein Bedarf an adäquaten Eichungsanlagen für die Überprüfung von Ladeanschlussvorrichtungen mit baulich darin integrierten Energiemessvorrichtungen.

Die WO 2014/022874 A1, welche auf die Anmelderin zurückgeht, beschreibt eine Ladeanschlussvorrichtung für Elektrofahrzeuge. Diese Ladeanschlussvorrichtung kann ein Mittel zur Messung und Überwachung der übertragenen Leistung, des Stromes, oder der Energiemenge beinhalten. Die Ladeanschlussvorrichtung ist weiters derart ausgeführt, dass in einem Ladebetriebsmodus elektrische Energie an der Ladeschnittstelle freigeschaltet ist, wenn von der Steuervorrichtung der Anschluss eines ladebereiten Elektrofahrzeuges festgestellt wurde. Darüber hinaus ist die Ladeanschlussvorrichtung von einer Bedienperson in einen Prüfmodus versetzbar, in welchem die elektrische Energie ohne einem Anschluss eines Elektrofahrzeuges auf die Ladeschnittstelle aufschaltbar oder durchgeschaltet ist. Dadurch kann eine solche Ladeanschlussvorrichtung von einem Elektromonteur fachgerecht installiert, unter Einhaltung einschlägiger Sicherheitsvorschriften an das Stromnetz angeschlossen werden und anschließend der elektrische Anschluss überprüft werden, ohne dass Simulationsgeräte für Elektrofahrzeuge oder spezielle Testadapter erforderlich sind.

Das Dokument von POPOV ANDREY ET AL: "Power hardware-in-the-loop test bench for tests and verification of EV and EVSE charging systems", 2014 IEEE INTERNATIONAL ELECTRIC VEHICLE CONFERENCE (IEVC), beschreibt ein System mit welchem die Kompatibilität von Lade- und von Kommunikationsvorgängen zwischen Ladeanschlussvorrichtungen (EVSE) und Elektrofahrzeugen (EV bzw. Plug-in EV) getestet werden kann. Dieses Testsystem soll dabei die Anforderung einer Kompatibilitätsprüfung zwischen verschiedenen Ladeanschlussvorrichtungen (EVSE) unterschiedlicher Technologie und verschiedenen Elektrofahrzeugen (EV) unterschiedlicher Technologie erfüllen können. Hierfür soll das Testsystem unter anderem Emulatoren für ein AC- oder DC-Versorgungsnetz umfassen. Mit diesem Testsystem sollen Energieversorgungsunternehmen wie z.B. Stromnetzbetreiber, Betreiber von Ladeanschlussvorrichtungen (EVSE), oder Anbieter von Elektrofahrzeugen (EV) die Möglichkeit bekommen, das planmäßige technische Zusammenspiel zwischen EVSE und EV im Vorfeld einer Markteinführung testen zu können. In diesem Testsystem, welches peripher zur Ladeanschlussvorrichtung aufgebaut ist, werden unter anderem Strom- und Spannungsmessungen durchgeführt. Es ist jedoch an keiner Stelle offenbart, dass eine Messung oder Berechnung der über die Ladeanschlussvorrichtung (EVSE) an das Elektrofahrzeug (EV) bereitgestellten Energiemenge erfolgen würde.

Das Dokument von NOHRER MARTIN ET AL: "Flexible test system architecture for electric vehicle charging infrastructure", 2014 IEEE INTERNATIONAL ELECTRIC VEHICLE CONFERENCE (IEVC), bezieht sich ebenso auf ein Testsystem mit diversen Emulatoren zur Überprüfung der technischen Kompatibilität zwischen Ladeanschlussvorrichtungen diverser Hersteller (EVSE) und Elektrofahrzeugen (EV) diverser Hersteller. Damit soll das Erreichen einer erhöhten globalen Nutzerakzeptanz von Elektrofahrzeugen unterstützt werden. Zudem soll die von Herstellern für Ladeanschlussvorrichtungen benötigte Zeit bis zur Markteinführung der Ladeinfrastruktur reduziert werden.

Das Dokument von SUN YUAN ET AL: "Research on Testing System and Test Method for Charging Facilities of Electric Vehicles", 2018 5TH IEEE INTERNATIONAL CONFERENCE ON CLOUD COMPUTING AND INTELLIGENCE SYSTEMS (CCIS), beschreibt ein weiteres Testsystem, mit welchem die Sicherheit und Zuverlässigkeit von Ladeinfrastruktur für Elektrofahrzeuge getestet werden soll. Auch damit soll der Industrialisierungs- und Markteinführungsprozess von Ladeanschlussvorrichtungen für Elektrofahrzeuge unterstützt werden.

Aufgabe der vorliegenden Erfindung war es, eine Vorrichtung oder ein Verfahren zur Verfügung zu stellen, mittels derer eine möglichst einfache bzw. wirtschaftliche Überprüfung der Messgenauigkeit von Ladeanschlussvorrichtungen mit integrierten Energiemessvorrichtungen ermöglicht ist.

Diese Aufgabe wird durch ein Verfahren gemäß den Ansprüchen gelöst. Das erfindungsgemäße Verfahren zur Kontrolle der Messgenauigkeit einer Ladeanschlussvorrichtung für Elektrofahrzeuge bezieht sich auf eine Ladeanschlussvorrichtung, welche zumindest folgende Komponenten umfasst:
- eine Eingangsschnittstelle zur Einspeisung von elektrischer Energie aus einem ortsfesten Stromversorgungsnetz in die Ladeanschlussvorrichtung,
- eine Ladeschnittstelle zur gesteuerten Abgabe von elektrischer Energie an ein Elektrofahrzeug,
- ein Leistungsschaltelement, insbesondere einen Schaltschütz oder ein Leistungs-Halbleiterschaltelement, zur gesteuerten Überleitung bzw. Freischaltung von elektrischer Energie an die Ladeschnittstelle,
- wenigstens eine Steuervorrichtung zur Überwachung und Steuerung von Funktionsabläufen zumindest der Ladeanschlussvorrichtung, und
- eine Energiemessvorrichtung, welche Energiemessvorrichtung zum Messen und Zählen der während Ladevorgängen von Elektrofahrzeugen bezogenen elektrischen Energiemenge vorgesehen ist. Das Kontrollverfahren für die Messgenauigkeit einer solchen Ladeanschlussvorrichtung umfasst zumindest folgende Schritte:
- Verbinden der Eingangsschnittstelle der Ladeanschlussvorrichtung, insbesondere der eingangs- oder netzseitigen Stromanschlüsse, und der Ladeschnittstelle der Ladeanschlussvorrichtung, insbesondere der ausgangs- oder fahrzeugseitigen Stromanschlüsse, mit einem Eichungskontrollgerät, welches Eichungskontrollgerät mindestens eine Spannungsquelle und mindestens eine Stromquelle umfasst, wobei das Eichungskontrollgerät als standardmäßiges Kontroll- bzw. Prüfgerät für Haushalts-Stromzähler ausgeführt sein kann,
- Umschalten der Ladeanschlussvorrichtung durch eine Bedienperson in einen Energiezählungs-Prüfmodus durch eine bewusste, vorbestimmte Handlung. Diese Umschaltung kann ausgehend von einem Ladebereitschaftsmodus erfolgen, welcher Ladebereitschaftsmodus bzw. Stand-by-Modus nach dem Hochfahren bzw. nach dem Einschalten der Ladeanschlussvorrichtung und/oder nach dem Beaufschlagen der Ladeanschlussvorrichtung mit elektrischer Energie vorliegen kann. Die bewusst durchzuführende, manuelle Umschaltung kann aber auch ausgehend von einem elektrisch unversorgten bzw. inaktiven Zustand der Ladeanschlussvorrichtung erfolgen. Die bedienerinitiierte Umschaltung der Ladeanschlussvorrichtung in den Energiezählungs-Prüfmodus umfasst zumindest folgende Schritte:
   -- Überführen einer Fahrzeug-Kommunikationsvorrichtung bzw. einer signaltechnischen Kommunikationsroutine der Ladeanschlussvorrichtung gegenüber einem Elektrofahrzeug in einen Kommunikations-Inaktivzustand, beispielsweise ausgehend von einem Kommunikations-Bereitschaftszustand,
   -- Deaktivieren von personenbezogenen Sicherheitsfunktionen der Ladeanschlussvorrichtung, vorzugsweise durch eine softwaretechnisch ausgelöste Inaktivschaltung von personenbezogenen Sicherheitsfunktionen durch die Steuervorrichtung,
   -- Schließen oder geschlossen halten des Leistungsschaltelementes,
- Durchführen der Kontrolle der Messgenauigkeit der Ladeanschlussvorrichtung, insbesondere der darin integrierten Energiemessvorrichtung unter Einbeziehung des angeschlossenen Eichungskontrollgerätes, welches als standardmäßiges Kontroll- bzw. Prüfgerät für Haushalts-Stromzähler ausgeführt ist bzw. ausgeführt sein kann.

Ein Vorteil des erfindungsgemäßen Verfahrens liegt darin, dass dadurch übliche und weit verbreitete Eichungskontrollgeräte bzw. Eichanlagen für standardmäßige Stromzähler von Haushalten bzw. Wohnanlagen auch für die Eichung bzw. Eichkontrolle der Ladeanschlussvorrichtung zum Laden von Elektrofahrzeugen genutzt werden können. Insbesondere ist dadurch keine besondere technische Adaption oder Neuanschaffung von Eichungskontrollgeräten erforderlich. Dies begünstigt zumindest indirekt die Wirtschaftlichkeit der Ladeanschlussvorrichtung und trägt somit dazu bei, gute Voraussetzungen für eine umfassende Verbreitung solcher Ladeanschlussvorrichtungen zu schaffen.

Neben wirtschaftlichen Vorteilen und Handhabungsvorteilen sind auch sicherheitstechnische Vorteile erzielbar. Nachdem in Zusammenhang mit einer Überprüfung der Energiemessvorrichtung in der Ladeanschlussvorrichtung ein Herauslösen der Energiemessvorrichtung aus der Ladeanschlussvorrichtung erübrigt ist, können aufwändige und funktional kritische Ab- oder Umklemmarbeiten an der Energiemessvorrichtung vermieden werden. Für die Dauer der Eichkontrolle muss somit nicht unmittelbar an der Energiemessvorrichtung ein Eichungskontrollgerät angeschlossen werden, sondern kann die dezidierte, klar erkennbare Eingangsschnittstelle und die standardmäßige zugreifbare Ladeschnittstelle der Ladeanschlussvorrichtung für die Eichungskontrolle verwendet werden. Darüber hinaus können durch die erfindungsgemäßen Maßnahmen auch elektronisch implementierte bzw. in die Steuervorrichtung der Ladeanschlussvorrichtung zumindest teilweise integrierte Energiemessvorrichtungen rasch und zweifelsfrei einer Eichkontrolle unterzogen werden.

Ein Vorteil der erfindungsgemäßen Maßnahmen liegt auch darin, dass die Energiemessvorrichtung zur Überprüfung der Genauigkeit aus der Ladeanschlussvorrichtung nicht ausgebaut werden muss. Somit können auch elektronisch implementierte bzw. zum Teil in die Steuervorrichtung integrierte Energiemessvorrichtungen problemlos einer Eichkontrolle unterzogen werden. Weil ein Ausbau der Energiemessvorrichtung erübrigt werden kann, sind seitens der Prüfperson auch keine speziellen Kenntnisse erforderlich und das Risiko von Beschädigungen der Ladeanschlussvorrichtung bleibt gering.

Darüber hinaus kann es zweckmäßig sein, wenn automatisch nach dem Ende der Kontrolle der Messgenauigkeit oder bei manueller Auslösung seitens einer Bedienperson, also auf Bedieneranforderung, folgende Schritte ausgeführt werden:
- Öffnen bzw. Trennen des Leistungsschaltelements, vorzugsweise automatisiert von Seiten der programmgesteuerten Steuervorrichtung,
- manuelles, bediener-initiiertes Auslösen oder automatisches Auslösen eines Befehls bzw. Triggers zur Reaktivierung der personenbezogenen Sicherheitsfunktionen der Ladeanschlussvorrichtung, wobei ein manueller Trigger beispielsweise durch einen Tastendruck definiert sein kann und eine automatische Auslösung durch einen Zeitablauf bzw. Countdown definiert sein kann,
- Umschalten der Ladeanschlussvorrichtung durch eine Bedienperson von dem Energiezählungs-Prüfmodus in den Ladebereitschaftsmodus bzw. Standardmodus durch eine bewusste, manuelle Handlung seitens einer Bedienperson, beispielsweise durch Betätigung von zumindest einem Schaltelement,
- Überführen der Fahrzeug-Kommunikationsvorrichtung oder der Kommunikationsroutine der Ladeanschlussvorrichtung gegenüber einem Elektrofahrzeug vom Kommunikations-Inaktivzustand in den Kommunikations-Bereitschaftszustand, vorzugsweise automatisiert von Seiten der programmgesteuerten Steuervorrichtung,
- manuelles Trennen der Eingangsschnittstelle, insbesondere der netzseitigen Anschlüsse, und der Ladeschnittstelle, insbesondere der fahrzeugseitigen Anschlüsse, vom Eichungskontrollgerät. Daraufhin kann die Ladeanschlussvorrichtung wieder ihrer eigentlichen Bestimmung zugeführt werden, indem sie gegebenenfalls am Einsatzort wieder montiert und an das Stromversorgungsnetz angeschlossen wird bzw. elektrisch mit dem Stromversorgungsnetz verbunden wird.

Durch die vorstehend gelisteten Maßnahmen kann nach Ausführung des Kontrollvorganges bezüglich der Messgenauigkeit der Ladeanschlussvorrichtung der Normal- bzw. Standard-Betriebszustand der Ladeanschlussvorrichtung gesichert wieder hergestellt werden. Insbesondere ist dadurch ein optimierter Kompromiss einerseits zwischen wiederhergestellter Funktions- und Personensicherheit und andererseits in Bezug auf Handhabungskomfort bzw. geringem Manipulationsaufwand geschaffen.

Entsprechend einer zweckmäßigen Maßnahme kann die manuelle Auslösung zur Reaktivierung der personenbezogenen Sicherheitsfunktionen durch eine manuelle Handlung des Bedieners definiert sein, beispielsweise durch eine Betätigung eines Tasters an bzw. in der Ladeanschlussvorrichtung erfolgen. Dadurch können auf Wunsch der Bedien- bzw. Prüfperson jederzeit die personenbezogenen Sicherheitsfunktionen wieder aktiviert werden, beispielsweise bei einem vorzeitigen Abbruch oder bei einer frühzeitigen Beendigung des Eichvorganges.

Alternativ oder in Kombination zu einer manuell ausgelösten Reaktivierung kann auch eine automatische Auslösung zur Reaktivierung der personenbezogenen Sicherheitsfunktionen erfolgen. Dies erfolgt zweckmäßigerweise durch ein Zeitglied, welches die personenbezogenen Sicherheitsfunktionen nach einer vordefinierten, maximalen Deaktivierungszeitdauer, beispielsweise nach 60 Minuten, automatisch reaktiviert. Dieses Zeitglied kann in der Steuervorrichtung implementiert sein. Sicherheitsverluste bei der Ladeanschlussvorrichtung infolge einer Unachtsamkeit der Bedienperson bzw. des Prüfers können so vermieden oder hintan gehalten werden. Vorzugsweise werden die personenbezogenen Sicherheitsfunktionen automatisch reaktiviert, eine Überführung der Ladeanschlussvorrichtung in den Ladebereitschaftsmodus erfolgt vorzugsweise jedoch erst durch eine zusätzliche, bewusste Handlung durch die Bedien- bzw. Prüfperson.

Gemäß einer vorteilhaften Ausprägung ist die bewusste Handlung zur Umschaltung in den Energiezählungs-Prüfmodus durch ein manuelles Betätigen von zumindest einem im Inneren eines Gehäuses der Ladeanschlussvorrichtung angeordneten Schaltelement definiert. Vorzugsweise wird dabei von der Bedien- bzw. Prüfperson zumindest eine Steckbrücke (Jumper) und/oder zumindest ein Dip-Switch in eine vorbestimmte Schaltstellung überführt. Ein manuell zu betätigendes Tastschaltelement kann gleichfalls vorgesehen sein. Dadurch ist sichergestellt, dass die Überführung der Ladeanschlussvorrichtung in den Energiezählungs-Prüfmodus, in welchem personenbezogene Sicherheitsfunktionen temporär deaktiviert sind, nur durch eine bewusste, manuelle Tätigkeit der Bedien- bzw. Prüfperson vorgenommen werden kann. Sicherheitsrisiken aufgrund von Unachtsamkeit können so vermieden bzw. deutlich hintan gehalten werden. Das Sicherheitsniveau kann dabei weiter gesteigert werden, wenn die bewusste Handlung zur Umschaltung in den Energiezählungs-Prüfmodus zumindest zwei zu erfüllende manuelle Handlungen, insbesondere an unterschiedlichen Schaltelementen, umfasst.

Sobald die Ladeanschlussvorrichtung in den dezidierten Energiezählungs-Prüfmodus überführt wurde, kann in vorteilhafter Art und Weise mit einem standardmäßigen Eichungskontrollgerät bzw. einer standardmäßigen Eichungsanlage, wie es/sie auch für haushaltsübliche Energie- bzw. Stromzähler verwendet wird, eine Eichungsüberprüfung vorgenommen werden. Insbesondere kann dadurch mittels einem standardmäßigen, extern zur Ladeanschlussvorrichtung angeordneten Eichungskontrollgerät, also einer üblichen Energiezählungs-Prüfvorrichtung, die Genauigkeit der Energiemessvorrichtung entsprechend geltendem Mess- und Eichrecht geprüft werden. Der Begriff "extern" bezieht sich dabei auf außerhalb des Gehäuses der Ladeanschlussvorrichtung angeordnet, aber in unmittelbarer Nähe zur Ladeanschlussvorrichtung positioniert. Damit kann eine gesetzeskonforme Überprüfung der Messgenauigkeit möglichst wirtschaftlich und unkompliziert vorgenommen werden.

Von Vorteil ist es weiters, wenn im Energiezählungs-Prüfmodus eine der deaktivierten Sicherheitsfunktionen eine Leistungsschaltelement-Überwachungsvorrichtung ist, welche in der Ladeanschlussvorrichtung deaktiviert wird. Diese Deaktivierung erfolgt vorzugsweise automatisiert durch die Steuervorrichtung, insbesondere softwaregesteuert innerhalb der Steuervorrichtung der Ladeanschlussvorrichtung. Diese Leistungsschaltelement-Überwachungsvorrichtung kann auch als Trennelement-Überwachung bezeichnet werden. Die Leistungsschaltelement-Überwachungsvorrichtung ist im Ladebereitschaftszustand der Ladeanschlussvorrichtung dazu vorgesehen, zu überprüfen, ob der Ist-Schaltzustand des Leistungsschaltelementes (offen oder geschlossen) dem Soll-Schaltzustand (offen oder geschlossen) des Leistungsschaltelementes entspricht. In Zusammenhang mit einem Schaltschütz als Leistungsschaltelement kann diese personenbezogene Sicherheitsfunktion auch als "Weld detection" bezeichnet sein. Beispielsweise kann von der Leistungsschaltelement-Überwachungsvorrichtung auch evaluiert bzw. überprüft werden, dass nur im Falle eines angeschlossenen, ladebereiten Elektrofahrzeuges das Leistungsschaltelement geschlossen bzw. durchgeschaltet ist.

Zweckmäßig kann es weiters sein, wenn im Energiezählungs-Prüfmodus eine der deaktivierten Sicherheitsfunktionen eine Fehlerstrom-Überwachungsvorrichtung, insbesondere eine Gleichstromfehler-Abschaltvorrichtung ist und diese in der Ladeanschlussvorrichtung deaktiviert wird. Dadurch kann die Eichungskontrolle möglichst zielgerichtet und effizient ausgeführt werden. Vor allem dann, wenn in der Ladeanschlussvorrichtung eine Fehlerstrom- bzw.

Differenzstrom-Überwachungsvorrichtung eingebaut ist, ist eine vorzugsweise automatische Deaktivierung derselben von Vorteil, wenn der dezidierte Energiezählungs-Prüfmodus eingeleitet bzw. aktiviert wird. Beim Hochfahren der Testströme des Eichungskontrollgerätes kann es sonst durch eine zu ungenaue Synchronisierung der Phasenströme zu ungewollten Auslösungen bzw. Abschaltungen kommen, welche den Eichungsablauf stören bzw. verzögern würden.

Entsprechend einer vorteilhaften Ausprägung kann vorgesehen sein, dass im Energiezählungs-Prüfmodus an der zu prüfenden Energiemessvorrichtung ein niedrigerer Messwertebereich eingestellt wird und/oder eine höhere Messgrößenauflösung an einem Anzeigemittel der Energiemessvorrichtung eingestellt wird, beispielsweise Wh anstelle von kWh, als im Ladebereitschaftsmodus an der Energiemessvorrichtung eingestellt ist. Dadurch können die Durchlaufzeiten für Prüfvorgänge deutlich verkürzt werden. Dies begünstigt die Wirtschaftlichkeit und kann die Akzeptanz der Ladeanschlussvorrichtung bei Prüfinstituten verbessern. Darüber hinaus kann dadurch mit wesentlich geringerer elektrischer Energie von Seiten des Eichungskontrollgerätes bzw. der Eichungsanlage eine eichrechtliche Überprüfung vorgenommen werden. Die Eichungskontrollgeräte können somit kompakt und verbrauchsarm ausgeführt sein. Weiters können dadurch erhöhte Belastungen des Eichungskontrollgerätes vermieden werden.

Gemäß einer praktikablen Maßnahme ist vorgesehen, dass im Energiezählungs-Prüfmodus eine Lichtquelle der Energiemessvorrichtung evaluiert wird, insbesondere eine Lichtquelle zum Aussenden von Lichtimpulsen, welche Lichtimpulse ein Informations-Äquivalent zu der von der Energiemessvorrichtung gemessenen elektrischen Energiemenge darstellen. Typischerweise ist diese Lichtquelle der Energiemessvorrichtung durch eine LED zum Abstrahlen von rotem Licht gebildet, deren Lichtimpulse bzw. deren Impulsfolge vom Eichungskontrollgerät ausgewertet werden. Insbesondere können dadurch vom Eichungskontrollgerät die Lichtimpulse aufgenommen und ausgewertet werden, was typischerweise durch einen Vergleich der vom Eichungskontrollgerät mit hoher Genauigkeit gemessenen Energiemenge und der von der Ladeanschlussvorrichtung erfassten Energiemenge erfolgt.

Entsprechend einer vorteilhaften Ausführungsform kann auch vorgesehen sein, dass die Lichtquelle der Energiemessvorrichtung im Ladebetriebsmodus der Ladeanschlussvorrichtung durch die Steuervorrichtung deaktiviert ist bzw. inaktiv geschaltet wird und bei Einnahme des Energiezählungs-Prüfmodus aktiviert wird, insbesondere durch die Steuervorrichtung funktionswirksam geschaltet wird. Dadurch wird in vorteilhafter Art und Weise vermieden, dass Laien bzw. uninformierte Benutzer der Ladeanschlussvorrichtung ein rotes Blinken bzw. Dauerleuchten der Lichtquelle der Energiemessvorrichtung als Störungsmeldung interpretieren. Vor allem bei einem Bezug hoher elektrischer Leistungen ist die Lichtquelle bzw. die rote LED optisch als dauerhaft leuchtend wahrzunehmen, was unter Umständen mit einem Fehlersignal verwechselt werden könnte. Durch die angegebenen Maßnahmen können derartige Irritationen und daraus möglicherweise abgeleitete Fehlhandlungen wirksam vermieden werden. Dennoch ist diese Funktionalität für die Anzeige eines laufenden Energiebezuges für die Eichungskontrolle verfügbar, wenn von der Ladeanschlussvorrichtung der dezidierte Energiezählungs-Prüfmodus eingenommen wird.

Gemäß einer vorteilhaften Maßnahme vergleicht das Eichungskontrollgerät die aus dessen Spannungs- und Stromquelle bereitgestellte Energiemenge mit der von der Energiemessvorrichtung in der Ladeanschlussvorrichtung gemessenen Energiemenge, insbesondere mit der von der Energiemessvorrichtung durch Lichtimpulse repräsentierten Energiemenge. Damit kann ein effizienter und zuverlässiger bzw. eichkonformer Prüfvorgang erreicht werden.

Entsprechend einer Weiterbildung ist es möglich, dass die Umschaltung in den Energiezählungs-Prüfmodus durch Eingabe eines gültigen Autorisierungscodes in die Steuervorrichtung oder in die Energiemessvorrichtung vorgenommen wird. Dadurch ist ein softwaretechnisch regulierter Zugriff auf den Energiezählungs-Prüfmodus geschaffen. Derartiges ist relativ kostengünstig implementierbar. Bei Bedarf kann dieser Zugriffsschutz problemlos verändert werden, insbesondere durch eine Codeänderung. Optional kann bei einem solchen Zugriffsschutz auf Werkzeuge, auf eine Zugriffsöffnung im Gehäuse, und/oder auf eine Öffnung des Gehäuses verzichtet werden. Insbesondere kann dadurch ein Zugriffs- bzw. Aktivierungsschutz für den Energiezählungs-Prüfmodus realisiert werden, welcher über eine Steckbrücke (Jumper) und/oder einen Dip-Schalter nicht realisierbar ist.

Die Aufgabe der Erfindung wird weiters durch eine Ladeanschlussvorrichtung gemäß den Ansprüchen gelöst. Die damit erzielbaren technischen Effekte und vorteilhaften Wirkungen sind den vorstehenden und den nachfolgenden Beschreibungsteilen zu entnehmen.

Zum besseren Verständnis der Erfindung wird diese anhand der nachfolgenden Figuren näher erläutert.

Es zeigen jeweils in stark vereinfachter, schematischer Darstellung:
- Fig. 1: ein beispielhaftes Aufladesystem umfassend eine Ladeanschlussvorrichtung und ein daran anschließbares Elektrofahrzeug;
- Fig. 2: die Ladeanschlussvorrichtung gemäß Fig. 1 in perspektivischer Ansicht auf die Gehäuserückseite;
- Fig. 3: die Ladeanschlussvorrichtung gemäß Fig. 1 in Explosionsdarstellung;
- Fig. 4: ein stark abstrahiertes Blockschaltbild über verschiedene Betriebsmodi der Ladeanschlussvorrichtung;
- Fig. 5: ein vereinfachtes Schaltbild einer Ladeanschlussvorrichtung mit einem daran angeschlossenen Eichungskontrollgerät;
- Fig. 6: ein vereinfachtes Ablaufdiagramm in Zusammenhang mit einer Eichkontrolle an einer Ladeanschlussvorrichtung gemäß Fig. 5.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

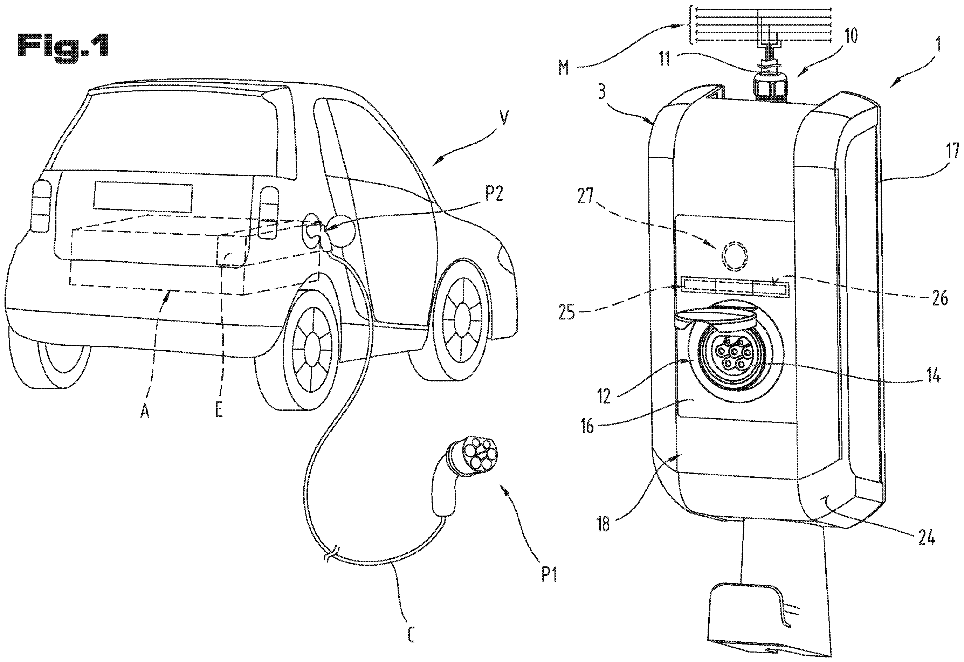

In den Fig. 1 bis 4 ist eine Ausführungsform einer Ladeanschlussvorrichtung 1 für Elektrofahrzeuge V veranschaulicht, welche Ladeanschlussvorrichtung 1 erfindungsgemäß betrieben werden kann bzw. mit welcher erfindungsgemäße Kontroll- und Steuerungsabläufe ausgeführt werden können. Diese Ladeanschlussvorrichtung 1 ist zum Aufladen bzw. Regenerieren des Energiespeichers A eines elektrisch betreibbaren Fahrzeuges vorgesehen, indem die Ladeanschlussvorrichtung 1 mit dem Energiespeicher A bzw. der Ladeelektronik E des Elektrofahrzeuges V elektrisch verbunden wird. Die Ladeanschlussvorrichtung 1 ist dabei als Bezugsquelle für elektrische Energie zu verstehen, über welche elektrische Energie in den wenigstens einen Energiespeicher A eines Elektrofahrzeuges V übertragen werden kann. Die Ladeanschlussvorrichtung 1 stellt vor allem dann, wenn die Ladeelektronik E fahrzeugseitig eingebaut ist, eine Art von intelligenter Stromtankstelle für Elektrofahrzeuge V dar. Es ist aber auch möglich, der Ladeanschlussvorrichtung 1 eine Ladeelektronik zuzuordnen bzw. in die Ladeanschlussvorrichtung 1 eine Ladeelektronik zu integrieren, welche die eingangsseitig eingespeiste, elektrische Energie in eine für die Aufladung des Energiespeichers A im Elektrofahrzeug V adäquate bzw. angepasste Form umwandelt und bereitstellt.

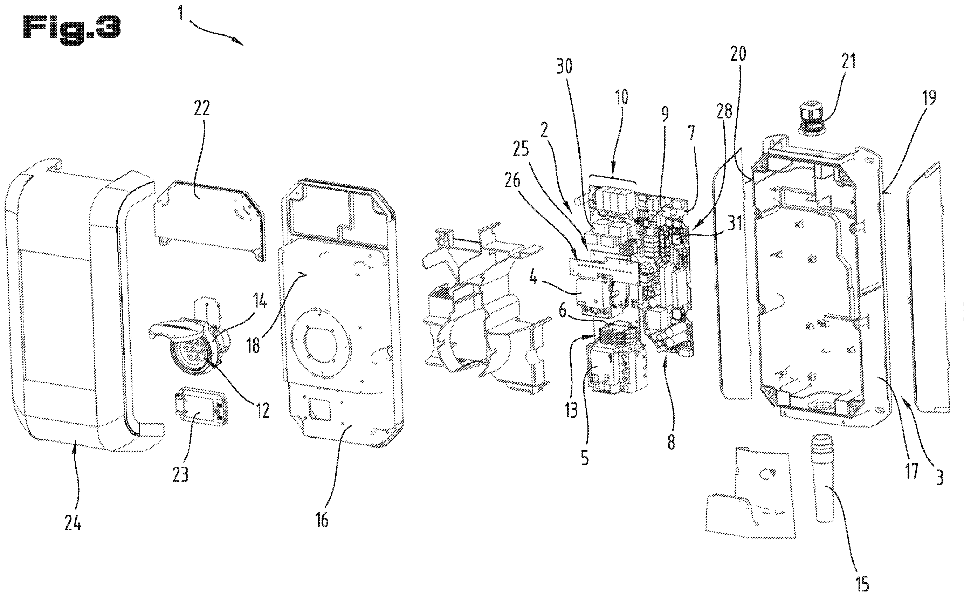

Wie am besten aus Fig. 3 ersichtlich ist, umfasst die Ladeanschlussvorrichtung 1 eine Mehrzahl von elektrotechnischen Komponenten 2, welche von einem beispielsgemäß mehrteiligen Gehäuse 3 umschlossen sind. Unter diesen elektrotechnischen Komponenten 2 sind auch elektronische Komponenten bzw. Baugruppen zu verstehen. Die elektrotechnischen Komponenten 2 dienen dabei zum Schalten und/oder Verteilen und/oder Messen und/oder Überwachen der aufgenommenen und/oder der abgegebenen, elektrischen Energie. Die elektrotechnischen Komponenten 2 können je nach Ausführungsform der Ladeanschlussvorrichtung 1 wenigstens eine Komponente ausgewählt aus der Bauteilgruppe umfassend Leistungsschaltelement 4, wie beispielsweise Schütz oder Leistungshalbleiter-Schaltmodul, FI-Schutzschalter bzw. Fehlerstrom-Überwachungsvorrichtung 5, Relais, Anschlussklemme 6, elektronischer Schaltkreis und dergleichen umfassen. Zu den elektrotechnischen Komponenten 2 zählen also auch elektronische Baugruppen. Die elektrotechnischen Komponenten 2 umfassen dabei zumindest eine sogenannte Printplatte bzw. Leiterplatte 7, auf welcher eine Mehrzahl von elektronischen Bauelementen zum Steuern und/oder Messen und/oder Überwachen der Energiezustände an der Ladeanschlussvorrichtung 1 bzw. im damit verbindbaren Elektrofahrzeug V angeordnet sind. Insbesondere ist eine Steuer- und/oder Auswertevorrichtung vorgesehen - im nachfolgenden kurz Steuervorrichtung 8 genannt - welche zumindest teilweise auf einer Leiterplatte 7 ausgebildet ist. Gegebenenfalls kann die Steuervorrichtung 8 wenigstens eine datentechnische Kommunikationsschnittstelle 9 - Fig. 3 - umfassen, über welche eine datentechnische Kommunikation der Steuervorrichtung 8 bzw. der Ladeanschlussvorrichtung 1 mit peripheren, elektronischen bzw. elektrotechnischen Einheiten, beispielsweise einer Abrechnungszentrale, ermöglicht ist. Alternativ oder zusätzlich zu einer drahtgebundenen Kommunikationsschnittstelle 9 ist es selbstverständlich auch möglich, auf Funktechnologie basierende Kommunikationsschnittstellen vorzusehen.

Die Ladeanschlussvorrichtung 1 weist wenigstens eine Eingangsschnittstelle 10 zur Zuführung bzw. Einspeisung von elektrischer Energie aus einem ortsfesten Stromversorgungsnetz M auf. Insbesondere wird der Ladeanschlussvorrichtung 1 via diese Eingangsschnittstelle 10 die zur Weiterleitung an ein angeschlossenes Elektrofahrzeug V benötigte, elektrische Energie zugeführt. Die Eingangsschnittstelle 10 ist dabei als Leitungsschnittstelle ausgeführt, welche vorzugsweise zum Anschluss von Kabeladern vorgesehen ist. Um die typischerweise benötigte, elektrische Leistung zur bzw. in die Ladeanschlussvorrichtung 1 übertragen zu können, sind zumeist Kabelquerschnitte zwischen 4 bis 16 mm² vorgesehen. Die Eingangsschnittstelle 10 fungiert somit als Anschlussstelle für eine elektrische Zuleitung 11 aus dem örtlich vorhandenen bzw. häuslichen Stromversorgungsnetz M. Die elektrische Energie wird dabei von einem einphasigen oder bevorzugt mehrphasigen Stromversorgungsnetz M mit standardisierter bzw. haushaltsüblicher Netzspannung bezogen, also beispielsweise im europäischen Raum in Höhe von 230 V AC bzw. 400 V AC. Beispielsgemäß erfolgt die Energiezuführung bzw. Stromzuleitung via wenigstens einen Durchbruch in der Gehäusedeckfläche der Ladeanschlussvorrichtung 1. Selbstverständlich ist es auch möglich, die Seitenwände bzw. die Rückwand und/oder die Bodenplatte des Gehäuses 3 mit wenigstens einer Kabeldurchführung für die elektrische Zuleitung 11 zu versehen.

Der elektrische Anschluss der Ladeanschlussvorrichtung 1 an das örtliche Stromversorgungsnetz M via die Zuleitung 11 ist dabei von einem Elektromonteur bzw. von einer Fachkraft vorzunehmen, welche über das entsprechende Fachwissen verfügt und die einschlägigen Sicherheitsbestimmungen kennt bzw. einhält.

Die Ladeanschlussvorrichtung 1 umfasst darüber hinaus wenigstens eine Ladeschnittstelle 12, 13 zur gesteuerten bzw. kontrollierten Abgabe von elektrischer Energie an ein daran angeschlossenes Elektrofahrzeug V. Diese wenigstens eine zweite Schnittstelle 12, 13 kann dabei wenigstens eine Steckbuchse 14 umfassen. Zudem oder alternativ dazu können Anschlussklemmen 6 - Fig. 3 - für wenigstens einen fixen Kabelabgang 15 bzw. für die Kabelenden eines fix anschließbaren bzw. angeschlossenen Ladekabels (nicht dargestellt) ausgebildet sein. Insbesondere umfasst die Ladeschnittstelle 12 der Ladeanschlussvorrichtung 1 wenigstens eine Steckbuchse 14, an welche ein Ladekabel C mit einem korrespondierenden Stecker P1 bedarfsweise anschließbar und auf Wunsch von der Ladeanschlussvorrichtung 1 wieder lösbar bzw. abkuppelbar ist. Mittels dem Ladekabel C und dem daran angeschlossenen Stecker P1 kann die von der Ladeanschlussvorrichtung 1 bereitgestellte bzw. jeweils verfügbare elektrische Energie an ein damit verbundenes Elektrofahrzeug V übertragen werden. Am zweiten Ende des Ladekabels C kann ein Stecker P2 vorgesehen sein, welcher mit einer korrespondierenden Steckbuchse am Elektrofahrzeug V bedarfsweise kuppelbar ist, um eine elektrische Leitungsverbindung zwischen der Ladeanschlussvorrichtung 1 und der Ladeelektronik E bzw. dem Energiespeicher A im Elektrofahrzeug V aufbauen zu können. Anstelle eines Steckers P2 für eine bedarfsweise An- und Abkopplung des Ladekabels C gegenüber dem Elektrofahrzeug V ist es auch möglich, dass das Ladekabel C fix bzw. permanent mit dem Elektrofahrzeug V bzw. mit dessen Ladeelektronik E verbunden ist. Insbesondere kann ein fahrzeugseitig eingebauter Aufroll- bzw. Aufnahmemechanismus für eine platzsparende und bequeme Unterbringung des Ladekabels C im Elektrofahrzeug V sorgen, wenn der Ladevorgang des Energiespeichers A abgeschlossen ist oder das Elektrofahrzeug V in Bewegung gesetzt werden soll. Bei der dargestellten Ausführungsform ist ein optional vorgesehener Kabelabgang 15 der Ladeanschlussvorrichtung 1 mit einer Kabelhalterung - Fig. 1, 3 - kombiniert, um eine geordnete Halterung von Restlängen bzw. der Gesamtlänge des Verbindungs- bzw. Ladekabels C zu einem Elektrofahrzeug V zu ermöglichen.

Um die elektrotechnischen Komponenten 2 möglichst rasch bzw. einfach im Gehäuse 3 unterbringen bzw. einbauen zu können, kann es zweckmäßig sein, wenn das Gehäuse 3 aus wenigstens einem ersten Gehäuseteil 16 und aus wenigstens einem weiteren Gehäuseteil 17 gebildet ist. Entsprechend der dargestellten, zweckmäßigen Ausführungsform ist das Gehäuse 3 als Wandgehäuse ausgeführt, wobei der erste Gehäuseteil 16 zumindest einen Teilabschnitt der Gehäusevorderseite 18 ausbildet und der weitere Gehäuseteil 17 zumindest einen Teilabschnitt der Gehäuserückseite 19 definiert. Das aus wenigstens einem ersten, beispielsgemäß frontseitigen Gehäuseteil 16 und aus wenigstens einem weiteren, beispielsgemäß rückseitigen Gehäuseteil 17 zusammengesetzte Gehäuse 3 stellt dabei in Verbindung mit wenigstens einem Abdichtungselement 20, 21 sicher, dass die darin eingebauten elektrotechnischen Komponenten 2 vor einer Berührung durch Personen sowie vor Feuchtigkeit und Schmutz geschützt sind. Gegebenenfalls kann - wie schematisch dargestellt - zumindest am ersten bzw. vorderen Gehäuseteil 16 wenigstens ein bedarfsweise lösbarer bzw. bedarfsweise aufklappbarer Deckel 22, 23 vorgesehen sein, mit welchem ein teilweiser Zugriff bzw. eine partielle Einsichtnahme in das Gehäuseinnere, beispielsweise auf einen FI-Schutzschalter 5 oder einen Leitungsschutzschalter oder auf die Eingangsschnittstelle 10, ermöglicht ist.

Entsprechend der dargestellten Ausführungsform kann weiters wenigstens ein Verkleidungselement 24 vorgesehen sein, welches zumindest Teilabschnitte des festigkeitsrelevanten Gehäuses 3 überdeckt. Durch einfaches Abnehmen des relativ filigran ausgebildeten Verkleidungselementes 24 - Fig. 1 - vom festigkeitsrelevanten Grundgehäuse umfassend den ersten und den weiteren Gehäuseteil 16, 17 besteht dann uneingeschränkter Zugriff auf ein bevorzugt werkzeuglos verstellbares Klappen- bzw. Deckelelement 23 für die Betätigung oder Rückstellung einer Fehlerstrom-Überwachungsvorrichtung 5 in Form eines FI-Schutzschalters bzw. Zugriff auf einen durch Schrauben befestigten Deckel 22 zum örtlich begrenzten Zugriff auf ein Netzanschlussfach im Gehäuse 3 bzw. auf die Eingangsschnittstelle 10 mit den Anschlussklemmen für die elektrische Zuleitung 11 aus dem örtlichen Stromversorgungsnetz M. Die Deckel 22 und/oder 23 stellen dabei eine vorteilhafte, optionale Ausführung dar, um örtlich begrenzten Zugriff auf nur einen Teil der elektrotechnischen Komponenten 2, insbesondere auf die Anschlussklemmen der Eingangsschnittstelle 10 und/oder auf die Fehlerstrom-Überwachungsvorrichtung 5 zu erhalten, während die sonstigen elektrotechnischen Komponenten 2 der Ladeanschlussvorrichtung 1 weitgehend geschützt bzw. verdeckt bleiben. Es ist aber auch möglich, auf diese Deckel 22 und/oder 23 zu verzichten und durch Abnehmen bzw. Montieren des ersten Gehäuseteils 16 den Zugriff auf die elektrotechnischen Komponenten 2 im Gehäuse 3 für Personen, insbesondere für Fachkräfte zu regulieren.

Die Ladeanschlussvorrichtung 1 kann weiters wenigstens ein steuerungstechnisches Ausgabeelement 25 zur Signalisierung von Betriebszuständen der Ladeanschlussvorrichtung 1 bzw. zur Anzeige von Ladezuständen des Energiespeichers A im Elektrofahrzeug V bzw. zur Visualisierung von betriebsrelevanten Daten der Ladeanschlussvorrichtung 1 gegenüber einem Benutzer, insbesondere gegenüber einer Wartungs- bzw. Bedienperson aufweisen. Dieses wenigstens eine Ausgabeelement 25 umfasst hierfür wenigstens ein visuell wahrnehmbares, optisches Anzeigemittel 26, mit welchem einer Person diverse Betriebszustände, wie zum Beispiel Ladezustände, Ladezeiten, Ladefortschritte, Störungszustände, Auswahlmöglichkeiten, Quittierungsaufforderungen, Energiebezugsmengen, oder dergleichen mitgeteilt werden können.

Zusätzlich zur Ausbildung von wenigstens einem optischen bzw. visuell erfassbaren Ausgabeelement 25 ist es selbstverständlich auch möglich, wenigstens ein akustisch wahrnehmbares Ausgabeelement, beispielsweise einen Summer, Lautsprecher oder dergleichen vorzusehen, um die Interaktion bzw. die insgesamt mögliche Informationsübermittlung an eine Bedienperson oder eine sonstige Person zu erweitern. Anstelle oder zusätzlich zu einem Anzeigemittel 26 mit einer Mehrzahl von Leuchtdioden ist es selbstverständlich auch möglich, ausreichend lichtstarke 7-Segmentanzeigen oder sonstige Displays, insbesondere grafikfähige Displays vorzusehen.

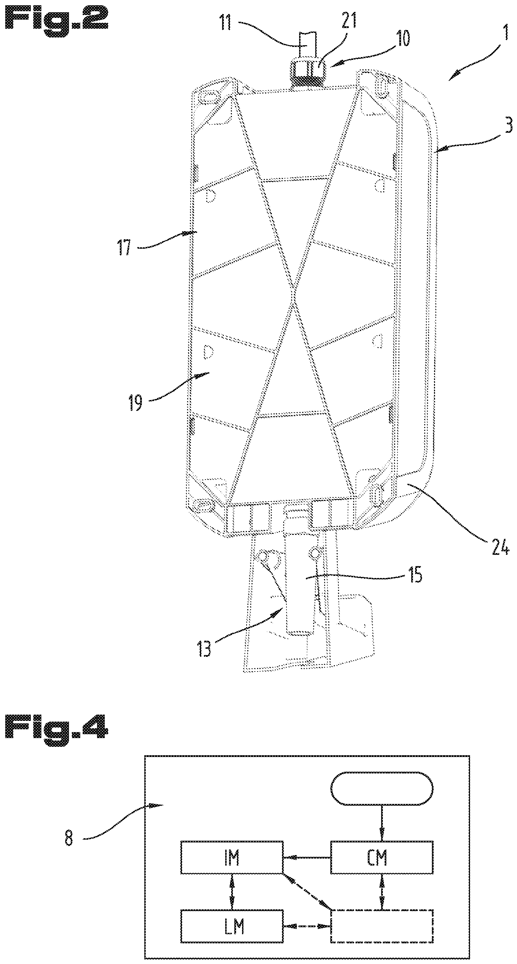

Entsprechend einer zweckmäßigen Ausgestaltung kann auch ein Signalisierungsmittel 27 ausgebildet sein (Fig 1), welches zur optischen und/oder akustischen Signalisierung des Vorliegens eines Energiezählungs-Prüfmodus CM (check mode) und/oder des Nicht-Vorliegens eines Ladebereitschaftsmodus IM (idle mode) der Ladeanschlussvorrichtung 1 vorgesehen ist, wie dies in Fig. 4 angedeutet und im Nachfolgenden im Detail erläutert wird.

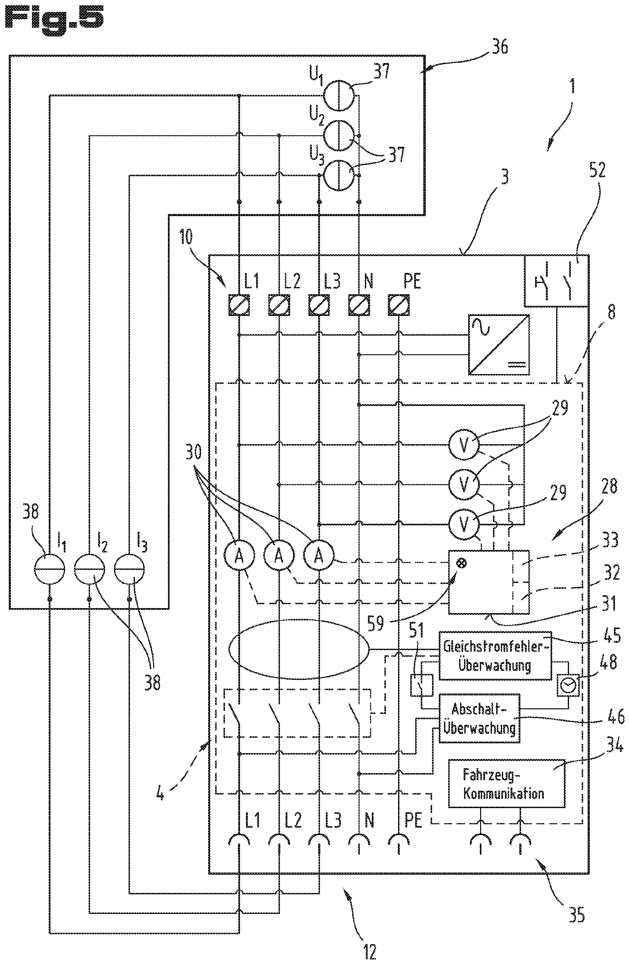

Wie am besten aus Fig. 5 ersichtlich ist, umfasst die Ladeanschlussvorrichtung 1 eine vorzugsweise rein elektronisch implementierte Energiemessvorrichtung 28 zum Messen der über die Ladeanschlussvorrichtung 1 an ein Elektrofahrzeug V abgegebenen elektrischen Energie. Eine solche rein elektronische Energiemessvorrichtung 28 ist im Gegensatz zu einem elektromechanischen Energiezähler (sogenannter Ferraris-Zähler) kompakt und leichtgewichtig.

Die Energiemessvorrichtung 28 umfasst zumindest einen Spannungsgeber 29 je elektrischer Phase bzw. je elektrischem Pfad zum Leistungsschaltelement 4 und zumindest einen Stromwandler 30 je elektrischer Phase bzw. je elektrischem Pfad zum Leistungsschaltelement 4. Der zumindest eine Spannungsgeber 29 und der zumindest eine Stromwandler 30 sind mit einem Mess-Controller 31 verbunden und übergeben so die jeweiligen Spannungs- bzw. Stromwerte an den Mess-Controller 31. Der Mess-Controller 31 errechnet aus den übergebenen Signalen bzw. Werten die jeweils übertragene bzw. bezogene, elektrische Energiemenge.

Die Energiemessvorrichtung 28, insbesondere der Mess-Controller 31, kann eine nicht-flüchtige Kalibrierdaten-Speichervorrichtung 32, insbesondere einen EEPROM-Speicher, umfassen. In der Kalibrierdaten-Speichervorrichtung 32 sind die für eine genaue Messung durch die Energiemessvorrichtung 28 erforderlichen Kalibrierdaten hinterlegt. Diese Kalibrierdaten sind geräteabhängig und variieren vor allem in Abhängigkeit der elektrischen Eigenschaften der Spannungsgeber 29 und der Stromwandler 30 bzw. in Abhängigkeit der ohmschen Widerstände der Leitungsverbindungen.

Die Energiemessvorrichtung 28 umfasst weiters eine nicht-flüchtige Energiedaten-Speichervorrichtung 33. In dieser Energiedaten-Speichervorrichtung 33 sind zumindest die von Ladesitzung zu Ladesitzung kontinuierlich ansteigenden Werte des Gesamtenergiebezuges an der Ladeanschlussvorrichtung 1 hinterlegbar. Eine Ladesitzung kann auch als Ladevorgang bezeichnet werden.

Zumindest einzelne Datensätze der Energiedaten-Speichervorrichtung 33 sind auf dem Anzeigemittel 26 an der Ladeanschlussvorrichtung 1 visualisierbar. Insbesondere ist dieses Anzeigemittel 26 unmittelbar am Gehäuse 3 angeordnet und von einem Benutzer der Ladeanschlussvorrichtung 1 ablesbar. Dieses Anzeigemittel 26 ist zur Anzeige von mess- und eichrechtlich relevanten Daten in Form von Klartext vorgesehen. Insbesondere ist darauf der Gesamt-Energieverbrauch seit der ersten Inbetriebnahme der Energiemessvorrichtung 28 ablesbar und kann gegebenenfalls die während eines Ladevorganges bezogene Energiemenge abgelesen werden. Alternativ oder in Kombination dazu kann am Anzeigemittel 26 die jeweilige Bezugsmenge von elektrischer Energie je Ladevorgang visualisiert und von einem Benutzer abgelesen werden.

Die internen Abläufe und die Betriebsweise der Ladeanschlussvorrichtung 1 werden primär durch die integrierte Steuervorrichtung 8 bestimmt bzw. mitbestimmt. Unter anderem ist dabei vorgesehen, dass die Ladeanschlussvorrichtung 1 bei Einnahme eines aktiven Ladebetriebsmodus LM elektrische Energie an der Ladeschnittstelle 12, 13 bereitstellt. Insbesondere wird im Ladebetriebsmodus LM elektrische Energie an der Ladeschnittstelle 12, 13 freigeschaltet, wenn von der Steuervorrichtung 8 der Anschluss eines ladebereiten Elektrofahrzeuges V festgestellt wurde. Diese Überprüfung in Bezug auf den tatsächlichen Anschluss eines ladebereiten Elektrofahrzeuges V wird unter anderem von der Steuervorrichtung 8 vorgenommen, welche hierzu bevorzugt auch mit der Ladeelektronik E eines angeschlossenen Elektrofahrzeuges V kommuniziert bzw. automatisiert überprüft, ob ein adäquates Ladekabel C angeschlossen ist.

In jenen Fällen bzw. zu jenen Zeitpunkten, bei welchen kein Elektrofahrzeug V angeschlossen ist, ist die Ladeschnittstelle 12, 13 bevorzugt energie- bzw. spannungslos geschaltet, was durch die Steuervorrichtung 8 und das wenigstens eine Leistungsschaltelement 4, insbesondere durch einen geöffneten Schütz oder ein gesperrtes Halbleiterschaltmodul, bewerkstelligt wird. Dieser Zustand der Ladeanschlussvorrichtung 1 stellt einen Ladebereitschaftsmodus IM (idle mode) dar. Diese Maßnahme erhöht die personenbezogene Sicherheit des Aufladesystems bzw. der Ladeanschlussvorrichtung 1.

Im Ladebereitschaftsmodus IM befindet sich eine Fahrzeug-Kommunikationsvorrichtung 34 in der Ladeanschlussvorrichtung 1 ebenso im Bereitschaftszustand. Diese Fahrzeug-Kommunikationsvorrichtung 34 ist zur signaltechnischen Kommunikation mit der Ladeelektronik E eines Elektrofahrzeuges V vorgesehen. Die Fahrzeug-Kommunikationsvorrichtung 34 in der Ladeanschlussvorrichtung 1 ist dabei über eine vorzugsweise leitungsgebundene Kommunikationsschnittstelle 35 mit der Ladeelektronik E eines Elektrofahrzeuges V verbindbar. Vorzugsweise sind die dafür notwendigen, signaltechnischen Kommunikationsleitungen in einem anschlusskompatiblen Ladekabel C zum Elektrofahrzeug V enthalten.

Wesentlich ist, dass die Ladeanschlussvorrichtung 1 von einer Bedienperson in einen gesonderten Energiezählungs-Prüfmodus CM (check mode) versetzbar ist, in welchem das Leistungsschaltelement 4, insbesondere ein Schütz oder ein Halbleiter-Schaltmodul, auch ohne einem Anschluss eines Elektrofahrzeuges V aktivierbar ist bzw. elektrisch leitend durchgeschaltet wird. In diesem Energiezählungs-Prüfmodus CM ist somit die Messgenauigkeit von der in der Ladeanschlussvorrichtung 1 implementieren Energiemessvorrichtung 28 verbessert überprüfbar. Demnach ist die Ladeanschlussvorrichtung 1 für Elektrofahrzeuge V derart konzipiert, dass sie einen ersten Betriebsmodus, insbesondere einen Ladebetriebsmodus LM aufweist, in welchem die Netz- bzw. Ladespannung an der Ladeschnittstelle 12, 13 von der Steuervorrichtung 8 erst dann freigeschaltet wird, wenn der ordnungsgemäße Anschluss eines ladebereiten Elektrofahrzeuges V festgestellt wurde.

Die erfindungsgemäße Ladeanschlussvorrichtung 1 weist darüber hinaus einen zweiten Betriebsmodus, insbesondere den Energiezählungs-Prüfmodus CM auf. Eine Aktivierung des Energiezählungs-Prüfmodus CM ist dabei gegen versehentliche oder unbefugte Aktivierung abgesichert und - insbesondere zu Kontrollzwecken im Zuge einer eichrechtlichen Kontrolle der Messgenauigkeit - von einer geschulten Bedien- bzw. Prüfperson bei Bedarf aktivierbar. In diesem Energiezählungs-Prüfmodus CM wird ausgehend von der Steuervorrichtung 8 das Leistungsschaltelement 4 aktiviert und somit eine elektrisch leitfähige Verbindung zwischen der Eingangsschnittstelle 10 und der Ladeschnittstelle 12, 13 aufgebaut, selbst wenn an der Ladeschnittstelle 12, 13 bzw.an der Fahrzeug-Kommunikationsschnittstelle 35 kein Elektrofahrzeug V angeschlossen ist bzw. über die Fahrzeug-Kommunikationsvorrichtung 34 keine signaltechnische Kommunikation zu einem Elektrofahrzeug V aufgebaut werden kann.

Durch die erfindungsgemäße Lösung kann eine geschulte bzw. fachkundige Prüfstelle - in der Regel eine von einem Eichungsinstitut zugelassene Prüforganisation - unter Einhaltung einschlägiger Sicherheitsmaßnahmen die Prüfenergie, insbesondere eine definierte Prüfspannung an der ausgangsseitigen Ladeschnittstelle 12, 13 freischalten bzw. durchschalten - und zwar ohne, dass ein Elektrofahrzeug V oder ein spezieller Adapter bzw. ein Simulationsgerät erforderlich wäre, welches den Anschluss eines Elektrofahrzeuges V simuliert. Die Bedienperson bzw. Prüf-Fachkraft kann dadurch mit einem herkömmlichen Eichungskontrollgerät 36 die Ladeanschlussvorrichtung 1 respektive deren darin integrierte Energiemessvorrichtung 28 auf ihre Messgenauigkeit überprüfen. Gegebenenfalls kann dabei auch eine stochastische bzw. stichprobenartige Überprüfung hinsichtlich ordnungsgemäßer Betriebszustände erfolgen. Insbesondere kann dadurch ohne spezielle Prüf- bzw. Testgeräte vor allem das Vorliegen einer eichrechtlich relevanten Messgenauigkeit von Energiebezügen kontrolliert werden. Optional ist es in diesem Zusammenhang auch möglich, die Auslösung einer in die Ladeanschlussvorrichtung 1 integrierten Fehlerstrom-Überwachungsvorrichtung 5, 45 zu überprüfen. Die erfindungsgemäßen Maßnahmen tragen dabei zu einer wesentlichen Vereinfachung und zu einer deutlich wirtschaftlicheren, eichrechtlichen Überprüfung der Messgenauigkeit der Ladeanschlussvorrichtung 1, insbesondere der Energiemessvorrichtung 28 bei.

Das Kontrollverfahren zur Kontrolle der Messgenauigkeit einer solchen Ladeanschlussvorrichtung 1 mit integrierter Energiemessvorrichtung 28 kann dabei folgende Schritte umfassen: Ein Eichungskontrollgerät 36 wird mit der Eingangsschnittstelle 10, d.h. mit zumindest einem der eingangs- oder netzseitigen Stromanschlüsse elektrisch verbunden. Zudem wird das Eichungskontrollgerät 36 mit der Ladeschnittstelle 12, 13, d.h. mit wenigstens einem der ausgangs- oder fahrzeugseitigen Stromanschlüsse elektrisch verbunden, wie dies am besten aus Fig. 5 ersichtlich ist. Das Eichungskontrollgerät 36 umfasst mindestens eine Spannungsquelle 37 und mindestens eine Stromquelle 38. Vorzugsweise sind bei einer dreiphasigen Ladeanschlussvorrichtung 1 drei Spannungsquellen 37 und drei Stromquellen 38 vorgesehen, um alle drei Phasenstränge der Ladeanschlussvorrichtung 1 ohne Umsteck- oder Umklemmarbeiten mit elektrischer Spannung und Strom beaufschlagen und prüfen zu können. Die wenigstens eine Spannungsquelle 37 liefert dabei ein Spannungswert-Eichnormal und die wenigstens eine Stromquelle 38 liefert ein Stromwert-Eichnormal. Mit diesen Spannungs- und Stromwert-Eichnormalen ausgehend vom Eichungskontrollgerät 36 wird die Ladeanschlussvorrichtung 1 beaufschlagt. Die vom Eichungskontrollgerät 36 der Ladeanschlussvorrichtung 1 aufgeprägte Energie wird dabei von der Energiemessvorrichtung 28 gemessen und der Messwert der Energiemessvorrichtung 28 wird mit einem Sollwert bzw. mit dem vom Eichungskontrollgerät 36 gemessenen Energiewert bzw. Anzeigesollwert verglichen. Liegen diese Messwerte innerhalb einer vorbestimmten Toleranz ist die eichrechtliche Überprüfung der Ladeanschlussvorrichtung 1 positiv abgeschlossen, andernfalls negativ. Von besonderem Nutzen ist dabei, dass die Kontrolle bzw. Abnahme der Ladeanschlussvorrichtung 1 seitens einer Eichrechtsbehörde mittels einer bewährten, bereits vorhandenen Standardanlage vorgenommen werden kann.

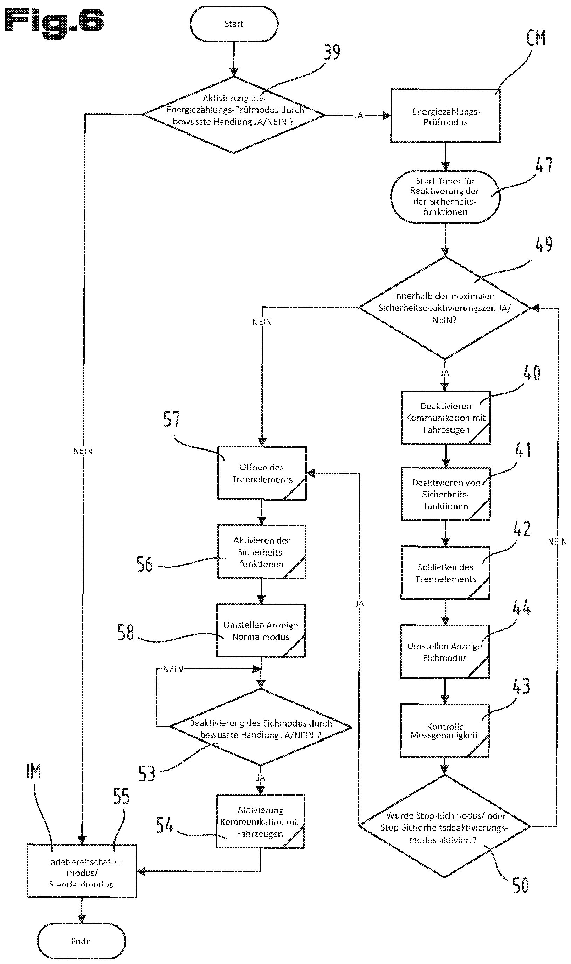

In Fig. 6 ist ein Ablauf mit diversen, vorteilhaften Verfahrensschritten veranschaulicht. Dieser Ablauf ermöglicht es, eine Eichkontrolle der Ladeanschlussvorrichtung 1 möglichst rasch, unkompliziert und sicher durchführen zu können.

In Schritt 39 wird die Ladeanschlussvorrichtung 1 von einer Bedienperson durch eine bewusste, vordefinierte Handlung beispielsweise ausgehend von dem Ladebereitschaftsmodus IM (idle mode) bzw. Standardmodus, insbesondere von einem Zustand nach dem Einschalten, oder ausgehend von einem allgemeinen "Power-On" der Ladeanschlussvorrichtung 1, in den Energiezählungs-Prüfmodus CM umgeschaltet. Diese Umschaltung in den Energiezählungs-Prüfmodus CM von Seiten einer Bedien- oder Prüfperson bzw. die entsprechende Initiierung zur Umschaltung in den Energiezählungs-Prüfmodus CM kann aber auch ausgehend von einem energielosen bzw. völlig inaktiven Zustand der Ladeanschlussvorrichtung 1 erfolgen, insbesondere durch hardwaremäßige Umstellungen bzw. manuelle Betätigungen an wenigstens einem Schaltelement 52 der Ladeanschlussvorrichtung 1.

Die Umschaltung der Ladeanschlussvorrichtung 1 in den Energiezählungs-Prüfmodus CM umfasst in weiterer Folge zumindest folgende zusätzliche Schritte:
- Überführen einer Kommunikationsroutine der Ladeanschlussvorrichtung 1 bzw. einer Kommunikationsprozedur von deren Fahrzeug-Kommunikationsvorrichtung 34 gegenüber einem Elektrofahrzeug V von einem Kommunikations-Bereitschaftszustand in einen Kommunikations-Inaktivzustand - Schritt 40;
- Deaktivieren von personenbezogenen Sicherheitsfunktionen der Ladeanschlussvorrichtung 1 - Schritt 41;
- Schließen oder geschlossen halten des Leistungsschaltelementes 4 - Schritt 42;
- Durchführen der Kontrolle der Messgenauigkeit der Ladeanschlussvorrichtung 1 respektive der darin integrierten Energiemessvorrichtung 28 unter Einbeziehung der Energieeinspeisung und/oder Energiemessung durch das angeschlossene Eichungskontrollgerät 36 - Schritt 43. Typischerweise ist dies ein Vergleich der Messwerte zwischen dem Eichungskontrollgerät 36 und der Energiemessvorrichtung 28.

Die zu prüfende Energiemessvorrichtung 28 muss somit von der Ladeanschlussvorrichtung 1 nicht baulich getrennt werden und auch nicht auf andere Weise physisch bzw. elektrisch von der Ladeanschlussvorrichtung 1 herausgelöst werden.

Um die Eichkontrolle bzw. den Prüfvorgang zu beschleunigen und/oder um die vom Eichungskontrollgerät 36 bereitzustellende Energie gering halten zu können, kann es zweckmäßig sein, wenn im Energiezählungs-Prüfmodus CM die messtechnische Auflösung der Energiemessvorrichtung 28 bzw. die Anzeigeauflösung des Anzeigemittels 26 für den Energiebezug umgestellt wird, insbesondere hochauflösender eingestellt wird - Schritt 44. Insbesondere kann im Energiezählungs-Prüfmodus CM an der zu prüfenden Energiemessvorrichtung 28 ein niedrigerer Messwertebereich eingestellt werden bzw. auf eine feinere Messgrößenauflösung der Anzeige der Energiemessvorrichtung 28 umgestellt werden, als im Ladebereitschaftsmodus IM bzw. Ladebetriebsmodus LM an der Energiemessvorrichtung 28 eingestellt ist. Beispielsweise kann eine Umstellung der Anzeigeauflösung am Anzeigemittel 26 auf Wh anstelle von kWh vorgenommen werden. Diese Umstellung erfolgt vorzugweise automatisiert durch die Steuervorrichtung 8 bzw. durch die Energiemessvorrichtung 28

Entsprechend einer vorteilhaften Ausprägung werden die Schritte 40 bis 42 und 44 werden infolge einer benutzerinitiierten Einleitung des Energiezählungs-Prüfmodus CM durch die Steuervorrichtung 8 vorzugsweise automatisch eingeleitet bzw. ausgeführt.

Die Deaktivierung von sicherheitsbezogenen Sicherheitsfunktionen in Schritt 41 kann eine Deaktivierung einer Fehlerstrom-Überwachungsvorrichtung 45 (Fig. 5) umfassen. Eine solche Fehlerstrom-Überwachungsvorrichtung 45 bewirkt im Falle des Auftretens von sicherheitskritischen Fehlerströmen eine automatische Abschaltung der Ladeanschlussvorrichtung 1 bzw. eine Unterbrechung des Leistungsschaltelementes 4. Diese Fehlerstrom-Überwachungsvorrichtung 45 kann auch als Differenzstrom-Überwachungsvorrichtung bezeichnet werden und als Gleichstromfehler-Abschaltvorrichtung ausgeführt sein. Vorzugsweise ist diese Fehlerstrom-Überwachungsvorrichtung 45, insbesondere eine Gleichstromfehler-Abschaltvorrichtung, elektronisch implementiert, vorzugsweise ein Teil der elektronischen Steuervorrichtung 8. Die Fehlerstrom-Überwachungsvorrichtung 45 kann dabei mit dem Leistungsschaltelement 4 leitungsverbunden bzw. funktionsgekoppelt sein und dazu eingerichtet sein, im Falle der Detektion eines unzulässig hohen Fehlerstromes das Leistungsschaltelement 4 zu öffnen bzw. zu sperren, wie dies in Fig. 5 durch eine strichlierte Linie schematisch veranschaulicht ist.

Alternativ oder in Kombination dazu kann die Deaktivierung von personenbezogenen Sicherheitsfunktionen gemäß Schritt 41 eine Deaktivierung einer Leistungsschaltelement-Überwachungsvorrichtung 46 (Fig. 5) für das Leistungsschaltelement 4 umfassen. Die Leistungsschaltelement-Überwachungsvorrichtung 46 kann durch eine Kontaktrücklesung eines Schaltschützes oder durch eine Strom- und/oder Spannungserfassung an der Abgangsseite des Leistungsschaltelementes 4 definiert sein. Die Leistungsschaltelement-Überwachungsvorrichtung 46, welche eine sicherheitsrelevante Komponente bzw. Funktion der Ladeanschlussvorrichtung 1 darstellt, kann auch als "Weld-Detection" bzw. als Schaltzustands-Detektionsvorrichtung bezeichnet werden, vor allem dann, wenn das Leistungsschaltelement 4 als Schaltschütz ausgeführt ist. Eine solche Leistungsschaltelement-Überwachungsvorrichtung 46 ist eine sicherheitsrelevante Komponente der Ladeanschlussvorrichtung 1 und überprüft bzw. eruiert das plan- bzw. ordnungsgemäße Schaltverhalten, insbesondere den Einschalt- und/oder Abschaltzustand des Leistungsschaltelementes 4. Dementsprechend ist durch die Leistungsschaltelement-Überwachungsvorrichtung 46 eine personenbezogene Sicherheitsfunktion gegeben, welche im Aktivzustand bzw. im Standard-Betrieb der Ladeanschlussvorrichtung 1 eine Fehlermeldung auslöst bzw. einen Ladevorgang verwehrt, wenn eine Diskrepanz zwischen Soll- und Ist-Schaltzustand des Leistungsschaltelementes 4 vorliegt.

Die personenbezogenen Sicherheitsfunktionen werden von der Steuervorrichtung 8 ausgeführt bzw. kontrolliert. Hierzu können Teile der Steuervorrichtung 8 auch als sogenannte Sicherheitssteuerung ausgeführt sein, welche eine sogenannte Einfehlersicherheit gewährleistet.

Gemäß Schritt 47 in Fig. 6 kann vorgesehen sein, dass eine Deaktivierungsdauer für zumindest einzelne oder alle personenbezogenen Sicherheitsfunktionen begrenzt ist und dass nach Ablauf der maximal vorgesehenen Deaktivierungsdauer zumindest einzelne oder vorzugsweise alle personenbezogenen Sicherheitsfunktionen automatisch wieder aktiviert werden. Insbesondere kann ein Zeitglied 48 (Timer) vorgesehen sein (Fig. 5), welches die maximal verfügbare Deaktivierungsdauer für personenbezogene Sicherheitsfunktionen begrenzt, und welches Zeitglied 48 nach Ablauf der maximal verfügbaren Deaktivierungsdauer die personenbezogenen Sicherheitsfunktionen automatisch wieder aktiviert bzw. deren automatische Aktivierung initiiert, wie dies in Entscheidungsschritt 49 in Fig. 6 veranschaulicht ist. Dabei kann auch vorgesehen sein, einen bevorstehenden Ablauf (Countdown) der Deaktivierungsdauer durch eine bewusste, benutzerinitiierte Handlung zu verlängern. Dementsprechend kann eine automatisierte Reaktivierung der personenbezogenen Sicherheitsfunktionen durch ein Zeitglied 48 (Timer) vorgesehen sein, welches Zeitglied 48 die personenbezogenen Sicherheitsfunktionen nach einer vordefinierten Deaktivierungszeitdauer, beispielsweise 60 Minuten, automatisch bzw. selbsttätig reaktiviert, wie dies im mittleren Zweig des Ablaufdiagrammes in Fig. 6 beispielhaft veranschaulicht ist.

Weiters kann eine bedienerinitiierte Reaktivierung der personenbezogenen Sicherheitsfunktionen vorgesehen sein, wie dies in Entscheidungsschritt 50 in Fig. 6 beispielhaft veranschaulicht ist. Insbesondere kann eine manuelle Auslösungsmöglichkeit in der Ladeanschlussvorrichtung 1 implementiert sein, welche zur Reaktivierung der personenbezogenen Sicherheitsfunktionen infolge einer bewussten manuellen Handlung des Bedieners, beispielsweise durch eine Betätigung eines Tasters 51 (Fig. 5), vorgesehen ist.

Wie vorstehend bereits ausgeführt, erfolgt die Umschaltung in den Energiezählungs-Prüfmodus CM vorzugsweise durch eine bewusste Handlung seitens einer Prüf- bzw. Bedienperson. Für diese Umschaltung kann eine manuelle Betätigung von zumindest einem im Inneren des Gehäuses 3 der Ladeanschlussvorrichtung 1 angeordneten Schaltelement 52 (Fig. 5) vorgesehen sein. Dieses zumindest eine Schaltelement 52 kann Tastschalter, Steckbrücken (Jumper) und DIP-Schalter umfassen.

Zweckmäßig ist es, wenn die bewusste Handlung zur Umschaltung in den Energiezählungs-Prüfmodus CM zumindest zwei manuellen Handlungen umfasst. Insbesondere kann vorgesehen sein, dass die Prüf- bzw. Bedienperson in bzw. an der Ladeanschlussvorrichtung 1 eine Schaltbrücke (Jumper) setzen muss und einen DIP-Schalter in einer vorbestimmten Weise einstellen muss. Durch die zwei notwendigen, manuellen Eingriffe und durch die Umsetzung in unterschiedlichen technischen Pfaden, insbesondere durch Hardware- und Software-Maßnahmen, kann nahezu ausgeschlossen werden, dass die Umschaltung in den Energiezählungs-Prüfmodus CM durch einen einzelnen Fehler zustande kommt. Die Verfügbarkeit der personenbezogenen Sicherheitsfunktionen wird dadurch nicht kompromittiert.

Das zumindest eine Schaltelement 52 zur manuellen bzw. bewussten Aktivierung des Energiezählungs-Prüfmodus CM wird in einer Sicherheitslogik der Steuervorrichtung 8 abgefragt und führt bei entsprechender Betätigung bzw. Einstellung zur Umschaltung in den Energiezählungs-Prüfmodus CM und zur Deaktivierung zumindest einzelner der vorstehend beschriebenen, personenbezogenen Sicherheitsfunktionen. Insbesondere wird das zumindest eine Schaltelement 52 von der Betriebssoftware der Ladeanschlussvorrichtung 1 bzw. von der Software der Steuervorrichtung 8 abgefragt. Wenn das zumindest eine Schaltelement 52 auf Aktivierung des Energiezählungs-Prüfmodus CM eingestellt ist, so werden nach dem Einschalten bzw. Hochfahren der Ladeanschlussvorrichtung 1 zumindest die personenbezogenen Sicherheitsfunktionen deaktiviert - Schritt 41 - und das Leistungsschaltelement 4 geschlossen bzw. durchgeschaltet - Schritt 42.

Alternativ oder in Kombination zu einer vordefinierten Betätigung bzw. Einstellung von dem wenigstens einen Schaltelement 52 kann vorgesehen sein, dass die Umschaltung in den Energiezählungs-Prüfmodus CM die Eingabe eines gültigen Autorisierungscodes in die Steuervorrichtung 8 oder in die Energiemessvorrichtung 28 umfasst. Dieser Autorisierungscode kann durch eine vordefinierte Betätigungssequenz von Schaltelementen 52 gebildet sein. Der Autorisierungscode kann auch durch ein mehrstelliges Kennwort definiert sein, welches in die Steuervorrichtung 8 einzugeben ist. Damit kann ein erhöhter Zugriffschutz realisiert werden, welcher über eine Steckbrücke (Jumper) und/oder einen DIP-Schalter nicht ermöglicht ist.

Zur Deaktivierung des Energiezählungs-Prüfmodus CM bzw. zur Herstellung der planmäßigen bzw. standardmäßigen Funktionalität der Ladeanschlussvorrichtung 1 ist es erforderlich, dass das zumindest eine Schaltelement 52 durch die Prüf- bzw. Bedienperson wieder in die Ausgangsstellung rückgeführt wird, wie dies in Entscheidungsschritt 53 in Fig. 6 beispielhaft veranschaulicht ist. Beispielsweise kann ein DIP-Schalter wieder in die Ausgangsposition überführt werden und eine Steckbrücke bzw. ein Kurzschlussbügel (Jumper) wieder abgezogen werden. Insbesondere wird in einem Schritt 54 nach der manuellen bzw. bewussten Deaktivierung des Energiezählungs-Prüfmodus CM die Fahrzeug-Kommunikationsvorrichtung 34 reaktiviert, sodass daraufhin eine signaltechnische Kommunikation mit einem mit der Ladeanschlussvorrichtung 1 verbundenen Elektrofahrzeug V wieder ermöglicht ist. Insbesondere ist in einem Schritt 55 der Ladebereitschaftsmodus IM bzw. Standardmodus der Ladeanschlussvorrichtung 1 wieder hergestellt.

Wie aus dem Ablaufdiagrammes in Fig. 6 ersichtlich ist, kann die Reaktivierung der personenbezogenen Sicherheitsfunktionen - Schritt 56 - nach Überschreitung der maximal verfügbaren Deaktivierungszeitdauer - Entscheidungsschritt 49 - oder nach einer manuellen Beendigung des Energiezählungs-Prüfmodus CM, oder nach einem manuellen Stoppbefehl für den Sicherheitsdeaktivierungsmodus erfolgen, beispielsweise durch eine Betätigung des Tasters 51 - Schritt 50. Gemäß dem mittleren Zweig im Ablaufdiagramm von Fig. 6 erfolgt zusätzlich zur Aktivierung der personenbezogenen Sicherheitsfunktionen - Schritt 56 - die Trennung bzw. Öffnung des Leistungsschaltelementes 4 - Schritt 57 - und die Umstellung des Anzeigemittels 26 der Energiemessvorrichtung 28 in den Normalmodus mit standardmäßiger Messwert- bzw. Anzeigeauflösung - Schritt 58. Dass die Anzeigeauflösung der Energiemessvorrichtung 28 bei Einnahme des Energiezählungs-Prüfmodus CM erhöht wird bzw. die erfasste Messgröße feiner aufgelöst wird, bietet den Vorteil, dass die Prüfzeiten deutlich verkürzt werden können. Insbesondere würden sich bei einer Verifikation der Messgenauigkeit mit kleinen Prüfströmen und bei einer Standardauflösung von 0,1 kWh relativ hohe Prüfzeiten ergeben.

Vorzugsweise werden nach dem Ende der Kontrolle der Messgenauigkeit der Energiemessvorrichtung 28, oder bei manueller bzw. bedarfsabhängiger Auslösung von Seiten einer Bedienperson folgende Schritte ausgeführt:
- Öffnen des Leistungsschaltelements 4 - Schritt 57,
- manuelles bzw. bedienerinitiiertes Auslösen oder automatisches Auslösen eines Befehls bzw. Triggers zur Reaktivierung der personenbezogenen Sicherheitsfunktionen der Ladeanschlussvorrichtung 1 - Schritt 56,
- Umschalten der Ladeanschlussvorrichtung 1 durch eine Bedienperson von dem Energiezählungs-Prüfmodus CM in den Ladebereitschaftsmodus IM bzw. Standardmodus durch eine bewusste Handlung - Schritt 53,
- Überführen der Fahrzeug-Kommunikationsvorrichtung 34 oder der Kommunikationsroutine der Ladeanschlussvorrichtung 1 gegenüber einem Elektrofahrzeug V vom Kommunikations-Inaktivzustand in den Kommunikations-Bereitschaftszustand - Schritt 54,
- Trennen der Eingangsschnittstelle 10 und der Ladeschnittstelle 12, 13 vom Eichungskontrollgerät 36.

Entsprechend einer zweckmäßigen Maßnahme ist vorgesehen, dass im Energiezählungs-Prüfmodus CM eine Lichtquelle 59 der Energiemessvorrichtung 28 evaluiert wird, insbesondere vom Eichungskontrollgerät 36 ausgewertet wird. Abgegebene Lichtimpulse der Lichtquelle 59, insbesondere die jeweiligen Blinkfrequenzen der Lichtquelle, stellen dabei ein Äquivalent zu der von der Energiemessvorrichtung 28 gemessenen elektrischen Energiemenge dar. Die Lichtquelle 59 zum energieäquivalenten Aussenden von Lichtimpulsen ist typischerweise durch eine LED zum Abstrahlen von rotem Licht gebildet, wie dies auch bei haushaltsüblichen Energiemessvorrichtungen bzw. bei einem standardmäßigen Smart-Meter realisiert ist.

Insbesondere ist vorgesehen, dass das Eichungskontrollgerät 36 bzw. die Prüfperson die aus der Spannungs- und Stromquelle 37, 38 bereitgestellte Energiemenge mit der von der Energiemessvorrichtung 28 in der Ladeanschlussvorrichtung 1 gemessenen Energiemenge vergleicht, insbesondere mit der von der Energiemessvorrichtung 28 durch Lichtimpulse repräsentierten Energiemenge vergleicht. Dadurch können standardmäßig aufgebaute Eichungskontrollgeräte 36 für die Überprüfung der Messgenauigkeit der Energiemessvorrichtung 28 innerhalb der Ladeanschlussvorrichtung 1 eingesetzt werden.

Das Ausführungsbeispiel zeigt mögliche Ausführungsvarianten, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt.

Der Schutzbereich ist durch die Ansprüche bestimmt. Die Beschreibung und die Zeichnungen sind jedoch zur Auslegung der Ansprüche heranzuziehen. Einzelmerkmale oder Merkmalskombinationen aus den gezeigten und beschriebenen unterschiedlichen Ausführungsbeispielen können für sich eigenständige erfinderische Lösungen darstellen. Die den eigenständigen erfinderischen Lösungen zugrundeliegende Aufgabe kann der Beschreibung entnommen werden.

Der Ordnung halber sei abschließend darauf hingewiesen, dass zum besseren Verständnis des Aufbaus Elemente teilweise unmaßstäblich und/oder vergrößert und/oder verkleinert dargestellt wurden.

**Bezugszeichenaufstellung**

| | | | | |
|---|---|---|---|---|
| | | | 29 | Spannungsgeber |
| 1 | Ladeanschlussvorrichtung | | 30 | Stromwandler |
| 2 | elektrotechn. Komponenten | | 31 | Mess-Controller |
| 3 | Gehäuse | | 32 | Kalibrierdaten-Speichervorrich-tung |
| 4 | Leistungsschaltelement | | | |
| 5 | Fehlerstrom-Überwachungsvor-richtung | | 33 | Energiedaten-Speichervorrichtung |
| 6 | Anschlussklemme | | 34 | Fahrzeug-Kommunikationsvor-richtung |
| 7 | Leiterplatte | | 35 | Kommunikationsschnittstelle |
| 8 | Steuervorrichtung | | | |
| | | | 36 | Eichungskontrollgerät |
| 9 | Kommunikationsschnittstelle | | 37 | Spannungsquelle |
| 10 | Eingangsschnittstelle | | 38 | Stromquelle |
| 11 | Zuleitung | | 39 | Schritt |
| 12 | Ladeschnittstelle | | 40 | Schritt |
| 13 | Ladeschnittstelle | | 41 | Schritt |
| 14 | Steckbuchse | | 42 | Schritt |
| 15 | Kabelabgang | | 43 | Schritt |
| 16 | erstes Gehäuseteil | | | |
| 17 | weiteres Gehäuseteil | | 44 | Schritt |
| 18 | Gehäusevorderseite | | 45 | Fehlerstrom-Überwachungsvor-richtung |
| 19 | Gehäuserückseite | | 46 | Leistungsschaltelement-Überwa-chungsvorrichtung |
| 20 | Abdichtungselement | | | |
| 21 | Abdichtungselement | | 47 | Schritt |
| 22 | Deckel | | | |
| 23 | Deckel | | 48 | Zeitglied |
| 24 | Verkleidungselement | | 49 | Entscheidungsschritt |
| 25 | Ausgabeelement | | 50 | Entscheidungsschritt |
| 26 | Anzeigemittel | | 51 | Taster |
| 27 28 | Signalisierungsmittel Energiemessvorrichtung | | 52 53 | Schaltelement Entscheidungsschritt |
| | | | 54 | Schritt |
| | | | | |
| 55 | Schritt | | | |
| 56 | Schritt | | | |
| 57 | Schritt | | | |
| 58 | Schritt | | | |
| 59 | Lichtquelle | | | |
| | | | | |
| A | Energiespeicher | | | |
| C | Ladekabel | | | |
| E | Ladeelektronik | | | |
| P1 | Stecker | | | |
| P2 | Stecker | | | |
| | | | | |
| V | Elektrofahrzeug | | | |
| M | Stromversorgungsnetz | | | |
| CM | Energiezählungs-Prüfmodus (check mode) | | | |
| IM | Ladebereitschaftsmodus mode)(idle | | | |
| LM | Ladebetriebsmodus (loading mode) | | | |

## Patentansprüche

1. Verfahren zur Kontrolle der Messgenauigkeit einer Ladeanschlussvorrichtung (1) für Elektrofahrzeuge (V), die Ladeanschlussvorrichtung (1) umfassend
- eine Eingangsschnittstelle (10) zur Einspeisung von elektrischer Energie aus einem ortsfesten Stromversorgungsnetz (M) in die Ladeanschlussvorrichtung (1),
- eine Ladeschnittstelle (12, 13) zur gesteuerten Abgabe von elektrischer Energie an ein Elektrofahrzeug (V),
- ein Leistungsschaltelement (4) zur gesteuerten Überleitung von elektrischer Energie an die Ladeschnittstelle (12, 13),
- wenigstens eine Steuervorrichtung (8) zur Überwachung und Steuerung von Funktionsabläufen zumindest der Ladeanschlussvorrichtung (1), und
- eine Energiemessvorrichtung (28), welche Energiemessvorrichtung (28) zum Messen und Zählen der während Ladevorgängen von Elektrofahrzeugen bezogenen elektrischen Energiemenge vorgesehen ist,
das Kontrollverfahren umfassend die Schritte:
- Verbinden der Eingangsschnittstelle (10) und der Ladeschnittstelle (12, 13) mit einem Eichungskontrollgerät (36), welches Eichungskontrollgerät (36) mindestens eine Spannungsquelle (37) und mindestens eine Stromquelle (38) umfasst,
- Umschalten der Ladeanschlussvorrichtung (1) durch eine Bedienperson in einen Energiezählungs-Prüfmodus (CM) durch eine bewusste Handlung, welche Umschaltung in den Energiezählungs-Prüfmodus (CM) zumindest folgende Schritte umfasst:
-- Überführen einer Fahrzeug-Kommunikationsvorrichtung (34) oder einer Kommunikationsroutine der Ladeanschlussvorrichtung (1) gegenüber einem Elektrofahrzeug (V) in einen Kommunikations-Inaktivzustand, beispielsweise ausgehend von einem Kommunikations-Bereitschaftszustand
-- Deaktivieren von personenbezogenen Sicherheitsfunktionen der Ladeanschlussvorrichtung (1),
-- Schließen oder geschlossen halten des Leistungsschaltelementes (4),
- Durchführen der Kontrolle der Messgenauigkeit der Ladeanschlussvorrichtung (1) mittels dem angeschlossenen Eichungskontrollgerät (36).

2. Verfahren nach Anspruch 1, wobei automatisch nach dem Ende der Kontrolle der Messgenauigkeit oder bei Auslösung seitens einer Bedienperson folgende Schritte ausgeführt werden:
- Öffnen des Leistungsschaltelements (4),
- manuelles Auslösen oder automatisches Auslösen eines Befehls zur Reaktivierung der personenbezogenen Sicherheitsfunktionen der Ladeanschlussvorrichtung (1),
- Umschalten der Ladeanschlussvorrichtung (1) durch eine Bedienperson von dem Energiezählungs-Prüfmodus (CM) in den Ladebereitschaftsmodus (IM) durch eine bewusste Handlung,
- Überführen der Fahrzeug-Kommunikationsvorrichtung (34) oder der Kommunikationsroutine der Ladeanschlussvorrichtung (1) gegenüber einem Elektrofahrzeug (V) vom Kommunikations-Inaktivzustand in den Kommunikations-Bereitschaftszustand,
- manuelles Trennen der Eingangsschnittstelle (10) und der Ladeschnittstelle (12, 13) vom Eichungskontrollgerät (36).

3. Verfahren nach Anspruch 2, wobei die manuelle Auslösung zur Reaktivierung der personenbezogenen Sicherheitsfunktionen durch eine manuelle Handlung einer Bedienperson, beispielsweise durch eine Betätigung eines Tasters (51), erfolgt.

4. Verfahren nach Anspruch 2 oder 3, wobei die automatische Auslösung zur Reaktivierung der personenbezogenen Sicherheitsfunktionen durch ein Zeitglied (48) erfolgt, welches die personenbezogenen Sicherheitsfunktionen nach einer vordefinierten, maximalen Deaktivierungszeitdauer, beispielsweise nach 60 Minuten, automatisch reaktiviert.

5. Verfahren nach einem der vorhergehenden Ansprüche, wobei die bewusste Handlung zur Umschaltung in den Energiezählungs-Prüfmodus (CM) durch ein manuelles Betätigen von zumindest einem im Inneren eines Gehäuses (3) der Ladeanschlussvorrichtung (1) angeordneten Schaltelement (52) vorgenommen wird.

6. Verfahren nach Anspruch 5, wobei die bewusste Handlung zur Umschaltung in den Energiezählungs-Prüfmodus (CM) zumindest zwei manuelle Handlungen umfasst.

7. Verfahren nach einem der vorhergehenden Ansprüche, wobei mittels dem extern zur Ladeanschlussvorrichtung (1) angeordneten Eichungskontrollgerät (36) die Genauigkeit der Energiemessvorrichtung (28) entsprechend geltendem Mess- und Eichrecht geprüft wird.

8. Verfahren nach einem der vorhergehenden Ansprüche, wobei im Energiezählungs-Prüfmodus (CM) eine der deaktivierten Sicherheitsfunktionen eine Leistungsschaltelement-Überwachungsvorrichtung (46) ist und diese in der Ladeanschlussvorrichtung (1) deaktiviert wird.

9. Verfahren nach einem der vorhergehenden Ansprüche, wobei im Energiezählungs-Prüfmodus (CM) eine der deaktivierten Sicherheitsfunktionen eine Fehlerstrom-Überwachungsvorrichtung (5, 45), insbesondere eine Gleichstromfehler-Abschaltvorrichtung ist und diese in der Ladeanschlussvorrichtung (1) deaktiviert wird.

10. Verfahren nach einem der vorhergehenden Ansprüche, wobei im Energiezählungs-Prüfmodus (CM) an der zu prüfenden Energiemessvorrichtung (28) ein niedrigerer Messwertebereich eingestellt wird und/oder eine höhere Messgrößenauflösung an einem Anzeigemittel (26) der Energiemessvorrichtung (28) eingestellt wird, beispielsweise Wh anstelle von kWh, als im Ladebereitschaftsmodus (IM) an der Energiemessvorrichtung (28) eingestellt ist.

11. Verfahren nach einem der vorherigen Ansprüche, wobei im Energiezählungs-Prüfmodus (CM) eine Lichtquelle (59) der Energiemessvorrichtung (28) evaluiert wird, insbesondere eine Lichtquelle (59) zum Aussenden von Lichtimpulsen, welche Lichtimpulse ein Äquivalent zu der von der Energiemessvorrichtung (28) gemessenen elektrischen Energiemenge darstellen.

12. Verfahren nach Anspruch 11, wobei die Lichtquelle (59) der Energiemessvorrichtung (28) im Ladebetriebsmodus (LM) der Ladeanschlussvorrichtung (1) durch die Steuervorrichtung (8) deaktiviert ist und bei Einnahme des Energiezählungs-Prüfmodus (CM) aktiviert wird, insbesondere durch die Steuervorrichtung (8) funktionswirksam geschaltet wird.

13. Verfahren nach Anspruch 11 oder 12, wobei das Eichungskontrollgerät (36) die aus dessen Spannungs- und Stromquelle (37, 38) bereitgestellte Energiemenge mit der von der Energiemessvorrichtung (28) in der Ladeanschlussvorrichtung (1) gemessenen Energiemenge vergleicht, insbesondere mit der von der Energiemessvorrichtung (28) durch Lichtimpulse repräsentierten Energiemenge vergleicht.

14. Verfahren nach einem der vorhergehenden Ansprüche, wobei die Umschaltung in den Energiezählungs-Prüfmodus (CM) durch Eingabe eines gültigen Autorisierungscodes in die Steuervorrichtung (8) oder in die Energiemessvorrichtung (28) vorgenommen wird.

15. Ladeanschlussvorrichtung für Elektrofahrzeuge, die Ladeanschlussvorrichtung (1) umfassend
- eine Eingangsschnittstelle (10) zur Einspeisung von elektrischer Energie aus einem ortsfesten Stromversorgungsnetz (M) in die Ladeanschlussvorrichtung (1),
- eine Ladeschnittstelle (12, 13) zur gesteuerten Abgabe von elektrischer Energie an ein Elektrofahrzeug (V),
- ein Leistungsschaltelement (4) zur gesteuerten Überleitung von elektrischer Energie an die Ladeschnittstelle (12, 13),
- wenigstens eine Steuervorrichtung (8) zur Überwachung und Steuerung von Funktionsabläufen zumindest der Ladeanschlussvorrichtung (1), und
- eine Energiemessvorrichtung (28), welche Energiemessvorrichtung (28) zum Messen und Zählen der während Ladevorgängen von Elektrofahrzeugen bezogenen elektrischen Energiemenge vorgesehen ist,
wobei die Ladeanschlussvorrichtung (1) durch eine bewusste Handlung einer Bedienperson in einen Energiezählungs-Prüfmodus (CM) überführbar ist, und wobei die Steuervorrichtung (8) der Ladeanschlussvorrichtung (1) zur Umschaltung in den Energiezählungs-Prüfmodus (CM) einbezogen ist und die Steuervorrichtung (8) der Ladeanschlussvorrichtung (1) dazu eingerichtet ist:
-- eine Fahrzeug-Kommunikationsvorrichtung (34) oder eine Kommunikationsroutine der Ladeanschlussvorrichtung (1) gegenüber einem Elektrofahrzeug (V) in einen Kommunikations-Inaktivzustand zu überführen, insbesondere ausgehend von einem Kommunikations-Bereitschaftszustand,
-- personenbezogene Sicherheitsfunktionen der Ladeanschlussvorrichtung (1) zu deaktivieren,
-- das Leistungsschaltelement (4) zu schließen oder geschlossen zu halten.

16. Ladeanschlussvorrichtung nach Anspruch 15, wobei die Steuervorrichtung (8) ferner dazu eingerichtet ist, automatisch nach dem Ende einer Kontrolle der Messgenauigkeit oder bei Auslösung seitens einer Bedienperson folgende Schritte auszuführen:
- Öffnen des Leistungsschaltelements (4),
- Reaktivieren der personenbezogenen Sicherheitsfunktionen der Ladeanschlussvorrichtung (1),
- Umschalten der Ladeanschlussvorrichtung (1) von dem Energiezählungs-Prüfmodus (CM) in den Ladebereitschaftsmodus (IM) basierend auf einer bewussten Handlung seitens einer Bedienperson,
- Überführen der Fahrzeug-Kommunikationsvorrichtung (34) oder der Kommunikationsroutine der Ladeanschlussvorrichtung (1) gegenüber einem Elektrofahrzeug (V) vom Kommunikations-Inaktivzustand in den Kommunikations-Bereitschaftszustand.

17. Ladeanschlussvorrichtung nach Anspruch 16, wobei die Steuervorrichtung (8) dazu eingerichtet ist, die personenbezogenen Sicherheitsfunktionen durch eine manuelle Handlung einer Bedienperson, beispielsweise durch eine Betätigung eines Tasters (51), zu reaktivieren.

18. Ladeanschlussvorrichtung nach Anspruch 16 oder 17, wobei die Steuervorrichtung (8) ein Zeitglied (48) umfasst, welches dazu eingerichtet ist die personenbezogenen Sicherheitsfunktionen nach einer vordefinierten, maximalen Deaktivierungszeitdauer, beispielsweise nach 60 Minuten, automatisch zu reaktivieren.

19. Ladeanschlussvorrichtung nach einem der Ansprüche 15 bis 18, wobei im Inneren eines Gehäuses (3) der Ladeanschlussvorrichtung (1) zumindest ein Schaltelement (52) angeordnet ist, welches durch eine manuelle Betätigung seitens einer Bedienperson zur Umschaltung in den Energiezählungs-Prüfmodus (CM) eingerichtet ist.

20. Ladeanschlussvorrichtung nach Anspruch 19, wobei das Schaltelement (52) ein erstes und ein zweites manuell zu betätigendes Schaltelement umfasst.

21. Ladeanschlussvorrichtung nach einem der Ansprüche 15 bis 20, wobei die Steuervorrichtung (8) dazu eingerichtet ist, im Energiezählungs-Prüfmodus (CM) als eine der personenbezogenen Sicherheitsfunktionen eine Leistungsschaltelement-Überwachungsvorrichtung (46) in der Ladeanschlussvorrichtung (1) zu deaktivieren.

22. Ladeanschlussvorrichtung nach einem der Ansprüche 15 bis 21, wobei die Steuervorrichtung (8) dazu eingerichtet ist, im Energiezählungs-Prüfmodus (CM) als eine der personenbezogenen Sicherheitsfunktionen eine Fehlerstrom-Überwachungsvorrichtung (5, 45), insbesondere eine Gleichstromfehler-Abschaltvorrichtung, in der Ladeanschlussvorrichtung (1) zu deaktivieren.

23. Ladeanschlussvorrichtung nach einem der Ansprüche 15 bis 22, wobei die Steuervorrichtung (8) oder die Energiemessvorrichtung (28) dazu eingerichtet ist, im Energiezählungs-Prüfmodus (CM) an der zu prüfenden Energiemessvorrichtung (28) einen niedrigeren Messwertebereich einzustellen und/oder eine höhere Messgrößenauflösung an einem Anzeigemittel (26) der Energiemessvorrichtung (28) vorzusehen, beispielsweise Wh anstelle von kWh, als im Ladebereitschaftsmodus (IM) an der Energiemessvorrichtung (28) eingestellt ist.

24. Ladeanschlussvorrichtung nach einem der Ansprüche 15 bis 23, wobei die Energiemessvorrichtung (28) eine Lichtquelle (59) umfasst und die von der Lichtquelle (59) abgebbaren Lichtimpulse ein Äquivalent zu der von der Energiemessvorrichtung (28) gemessenen elektrischen Energiemenge darstellen.

25. Ladeanschlussvorrichtung nach Anspruch 24, wobei die Steuervorrichtung (8) oder die Energiemessvorrichtung (28) dazu eingerichtet ist, die Lichtquelle (59) der Energiemessvorrichtung (28) im Ladebetriebsmodus (LM) der Ladeanschlussvorrichtung (1) zu deaktivieren und bei Einnahme des Energiezählungs-Prüfmodus (CM) funktionswirksam zu schalten.

26. Ladeanschlussvorrichtung nach einem der Ansprüche 15 bis 25, wobei die Steuervorrichtung (8) dazu eingerichtet ist, durch Eingabe eines gültigen Autorisierungscodes in die Steuervorrichtung (8) oder in die Energiemessvorrichtung (28) in den Energiezählungs-Prüfmodus (CM) umzuschalten.

## Claims

1. A method for checking the measurement accuracy of a charging connection device (1) for electric vehicles (V), the charging connection device (1) comprising
- an input interface (10) for feeding electrical energy from a stationary power supply network (M) into the charging connection device (1),
- a charging interface (12, 13) for the controlled delivery of electrical energy to an electric vehicle (V),
- a power switching element (4) for the controlled transfer of electrical energy to the charging interface (12, 13),
- at least one control device (8) for monitoring and controlling functional sequences of at least the charging connection device (1), and
- an energy measuring device (28), which energy measuring device (28) is provided for measuring and counting the amount of electrical energy drawn during charging processes of electric vehicles,
the control method comprising the steps of:
- connecting the input interface (10) and the charging interface (12, 13) to a calibration control device (36), which calibration control device (36) comprises at least one voltage source (37) and at least one current source (38),
- switching the charging connection device (1) by an operator to an energy metering test mode (CM) by a deliberate action, which switching to the energy metering test mode (CM) comprises at least the following steps:
-- transferring a vehicle communication device (34) or a communication routine of the charging connection device (1) with respect to an electric vehicle (V) to a communication inactive state, for example starting from a communication standby state,
-- deactivating personal safety functions of the charging connection device (1),
-- closing or keeping closed the power switching element (4),
- carrying out the check of the measurement accuracy of the charging connection device (1) by means of the connected calibration control device (36).

2. The method according to claim 1, wherein the following steps are carried out automatically after the end of the check of the measurement accuracy or when triggered by an operator:
- opening of the power switching element (4),
- manual triggering or automatic triggering of a command for reactivating the personal safety functions of the charging connection device (1),
- switching of the charging connection device (1) by an operator from the energy metering test mode (CM) to the charging standby mode (IM) by a deliberate action,
- transferring the vehicle communication device (34) or the communication routine of the charging connection device (1) with respect to an electric vehicle (V) from the communication inactive state to the communication standby state,
- manually disconnecting the input interface (10) and the charging interface (12, 13) from the calibration control device (36).

3. The method according to claim 2, wherein the manual triggering for reactivating the personal safety functions is carried out by a manual action of an operator, for example by actuating a button (51).

4. The method according to claim 2 or 3, wherein the automatic triggering for reactivating the personal safety functions is carried out by a timer (48) which automatically reactivates the personal safety functions after a predefined maximum deactivation period, for example after 60 minutes.

5. The method according to one of the preceding claims, wherein the deliberate action for switching to the energy metering test mode (CM) is performed by a manual actuation of at least one switching element (52) arranged inside a housing (3) of the charging connection device (1).

6. The method according to claim 5, wherein the deliberate action for switching to the energy metering test mode (CM) comprises at least two manual actions.

7. The method according to one of the preceding claims, wherein the accuracy of the energy measuring device (28) is checked in accordance with applicable measurement and calibration law by means of the calibration control device (36) arranged externally to the charging connection device (1).

8. The method according to one of the preceding claims, wherein in the energy metering test mode (CM) one of the deactivated safety functions is a power switching element monitoring device (46) and the latter is deactivated in the charging connection device (1).

9. The method according to one of the preceding claims, wherein in the energy metering test mode (CM) one of the deactivated safety functions is a fault current monitoring device (5, 45), in particular a DC fault cut-off device, and the latter is deactivated in the charging connection device (1).

10. The method according to one of the preceding claims, wherein in the energy metering test mode (CM) a lower measured value range is set on the energy measuring device (28) to be tested and/or a higher measured variable resolution is set on a display means (26) of the energy measuring device (28), for example Wh instead of kWh, than is set on the energy measuring device (28) in the charging standby mode (IM).

11. The method according to one of the preceding claims, wherein in the energy metering test mode (CM) a light source (59) of the energy measuring device (28) is evaluated, in particular a light source (59) for emitting light pulses, which light pulses represent an equivalent to the amount of electrical energy measured by the energy measuring device (28).

12. The method according to claim 11, wherein the light source (59) of the energy measuring device (28) is deactivated by the control device (8) in the charging operating mode (LM) of the charging connection device (1) and is activated when the energy metering test mode (CM) is entered, in particular is switched to be functionally effective by the control device (8).

13. The method according to claim 11 or 12, wherein the calibration control device (36) compares the amount of energy provided from its voltage and current source (37, 38) with the amount of energy measured by the energy measuring device (28) in the charging connection device (1), in particular compares it with the amount of energy represented by light pulses from the energy measuring device (28).

14. The method according to one of the preceding claims, wherein the switching to the energy metering test mode (CM) is performed by entering a valid authorization code into the control device (8) or into the energy measuring device (28).

15. A charging connection device for electric vehicles, the charging connection device (1) comprising
- an input interface (10) for feeding electrical energy from a stationary power supply network (M) into the charging connection device (1),
- a charging interface (12, 13) for the controlled delivery of electrical energy to an electric vehicle (V),
- a power switching element (4) for the controlled transfer of electrical energy to the charging interface (12, 13),
- at least one control device (8) for monitoring and controlling functional sequences of at least the charging connection device (1), and
- an energy measuring device (28), which energy measuring device (28) is provided for measuring and counting the amount of electrical energy drawn during charging processes of electric vehicles,
wherein the charging connection device (1) can be switched to an energy metering test mode (CM) by a deliberate action of an operator, and wherein the control device (8) of the charging connection device (1) is included for switching to the energy metering test mode (CM) and the control device (8) of the charging connection device (1) is configured for:
-- transferring a vehicle communication device (34) or a communication routine of the charging connection device (1) with respect to an electric vehicle (V) into a communication inactive state, in particular starting from a communication standby state,
-- deactivating personal safety functions of the charging connection device (1),
-- closing or keeping closed the power switching element (4).

16. The charging connection device according to claim 15, wherein the control device (8) is furthermore configured to automatically carry out the following steps after the end of a measurement accuracy check or when triggered by an operator:
- opening of the power switching element (4),
- reactivating the personal safety functions of the charging connection device (1),
- switching the charging connection device (1) from the energy metering test mode (CM) to the charging standby mode (IM) based on a deliberate action by an operator,
- transferring the vehicle communication device (34) or the communication routine of the charging connection device (1) with respect to an electric vehicle (V) from the communication inactive state to the communication standby state.

17. The charging connection device according to claim 16, wherein the control device (8) is configured to reactivate the personal safety functions by a manual action of an operator, for example by actuating a button (51).

18. The charging connection device according to claim 16 or 17, wherein the control device (8) comprises a timer (48) which is configured to automatically reactivate the personal safety functions after a predefined maximum deactivation period, for example after 60 minutes.

19. The charging connection device according to one of claims 15 to 18, wherein at least one switching element (52) is arranged in the interior of a housing (3) of the charging connection device (1), which switching element is configured for switching to the energy metering test mode (CM) by manual actuation by an operator.

20. The charging connection device according to claim 19, wherein the switching element (52) comprises a first and a second manually operable switching element.

21. The charging connection device according to one of claims 15 to 20, wherein the control device (8) is arranged to deactivate a power switching element monitoring device (46) in the charging connection device (1) as one of the personal safety functions in the energy metering test mode (CM).

22. The charging connection device according to one of claims 15 to 21, wherein the control device (8) is arranged to deactivate a fault current monitoring device (5, 45), in particular a DC fault cut-off device, in the charging connection device (1) as one of the personal safety functions in the energy metering test mode (CM).

23. The charging connection device according to one of claims 15 to 22, wherein the control device (8) or the energy measuring device (28) is configured to set a lower measured value range in the energy metering test mode (CM) on the energy measuring device (28) to be tested and/or to provide a higher measured value resolution on a display means (26) of the energy measuring device (28), for example Wh instead of kWh, than is set on the energy measuring device (28) in the charging standby mode (IM).

24. The charging connection device according to one of claims 15 to 23, wherein the energy measuring device (28) comprises a light source (59) and the light pulses emittable by the light source (59) represent an equivalent to the amount of electrical energy measured by the energy measuring device (28).

25. The charging connection device according to claim 24, wherein the control device (8) or the energy measuring device (28) is configured to deactivate the light source (59) of the energy measuring device (28) in the charging operating mode (LM) of the charging connection device (1) and to switch it functionally effective upon entering the energy metering test mode (CM).

26. The charging connection device according to one of claims 15 to 25, wherein the control device (8) is configured to switch to the energy metering test mode (CM) by entering a valid authorization code into the control device (8) or into the energy measuring device (28).

## Revendications

1. Procédé de contrôle de la précision de mesure d'un dispositif de raccordement de charge (1) pour des véhicules électriques (V), ce dispositif de raccordement de charge (1) comprenant
- une interface d'entrée (10) pour l'introduction en énergie électrique provenant d'un réseau d'alimentation électrique fixe (M) dans le dispositif de raccordement de charge (1),
- une interface de charge (12, 13) pour la distribution contrôlée d'énergie électrique à un véhicule électrique (V),
- un élément de commutation de puissance (4) pour la transmission contrôlée d'énergie électrique à l'interface de charge (12, 13),
- au moins un dispositif de commande (8) pour la surveillance et la commande de processus fonctionnels au moins du dispositif de raccordement de charge (1) et
- un dispositif de mesure d'énergie (28), ce dispositif de mesure d'énergie (28) étant conçu pour la mesure et le comptage de la quantité d'énergie électrique consommée pendant les processus de charge des véhicules électriques,
ce procédé de contrôle comprenant les étapes suivantes :
- raccordement de l'interface d'entrée (10) et de l'interface de charge (12, 13) avec un appareil de contrôle d'étalonnage (36), cet appareil de contrôle d'étalonnage (36) comprenant au moins une source de tension (37) et au moins une source de courant (38),
- commutation du dispositif de raccordement de charge (1) par un opérateur dans un mode de vérification de comptage d'énergie (CM) à l'aide d'une action consciente, cette commutation dans le mode de vérification de comptage d'énergie (CM) comprenant au moins les étapes suivantes :
- passage d'un dispositif de communication de véhicule (34) ou d'une routine de communication du dispositif de raccordement de charge (1) par rapport à un véhicule (V) dans un état inactif de communication, par exemple à partir d'un état de veille de communication
- désactivation de fonctions de sécurité personnelles du dispositif de raccordement de charge (1),
- fermeture ou maintien de la fermeture de l'élément de commutation de puissance (4),
- exécution du contrôle de la précision de mesure du dispositif de raccordement de charge (1) au moyen de l'appareil de contrôle d'étalonnage (36) raccordé.

2. Procédé selon la revendication 1, dans lequel, automatiquement après la fin du contrôle de la précision de mesure ou lors du déclenchement par un opérateur, les étapes suivantes sont exécutées :
- ouverture de l'élément de commutation de puissance (4),
- déclenchement manuel ou déclenchement automatique d'une instruction pour la réactivation des fonctions de sécurité personnelles du dispositif de raccordement de charge (1),
- commutation du dispositif de raccordement de charge (1) par un opérateur du mode de vérification de comptage d'énergie (CM) vers le mode de veille de charge (IM) à l'aide d'une action consciente,
- passage du dispositif de communication de véhicule (34) ou de la routine de communication du dispositif de raccordement de charge (1) par rapport à un véhicule (V) de l'état inactif de communication vers l'état de veille de communication,
- déconnexion manuelle de l'interface d'entrée (10) et de l'interface de charge (12, 13) par l'appareil de contrôle d'étalonnage (36).

3. Procédé selon la revendication 2, dans lequel le déclenchement manuel pour la réactivation des fonctions de sécurité personnelles a lieu à l'aide d'une action manuelle d'un opérateur, par exemple à l'aide de l'actionnement d'un bouton (51).

4. Procédé selon la revendication 2 ou 3, dans lequel le déclenchement automatique pour la réactivation des fonctions de sécurité personnelles a lieu à l'aide d'un temporisateur (48), qui réactive automatiquement les fonctions de sécurité personnelles après une durée de désactivation maximale prédéfinie, par exemple après 60 minutes.

5. Procédé selon l'une des revendications précédentes, dans lequel l'action consciente de commutation dans le mode de vérification de comptage d'énergie (CM) est effectuée à l'aide d'un actionnement manuel d'au moins un élément de commutation (52) disposé à l'intérieur d'un boîtier (3) du dispositif de raccordement de charge (1).

6. Procédé selon la revendication 5, dans lequel l'action consciente de commutation dans le mode de vérification de comptage d'énergie (CM) comprend au moins deux actions manuelles.

7. Procédé selon l'une des revendications précédentes, dans lequel, au moyen de l'appareil de contrôle d'étalonnage (36) disposé de manière externe par rapport au dispositif de raccordement de charge (1), la précision du dispositif de mesure d'énergie (28) est vérifiée en fonction de règles de mesure et d'étalonnage.

8. Procédé selon l'une des revendications précédentes, dans lequel, dans le mode de vérification de comptage d'énergie (CM), une des fonctions de sécurité désactivées est un dispositif de surveillance d'élément de commutation de puissance (46) et celui-ci est désactivé dans le dispositif de raccordement de charge (1).

9. Procédé selon l'une des revendications précédentes, dans lequel, dans le mode de vérification de comptage d'énergie (CM), une des fonctions de sécurité désactivées est un dispositif de surveillance de courant d'erreur (5, 45), plus particulièrement un dispositif de coupure d'erreur de courant continu et celui-ci est désactivé dans le dispositif de raccordement de charge (1).

10. Procédé selon l'une des revendications précédentes, dans lequel, dans le mode de vérification de comptage d'énergie (CM), au niveau du dispositif de mesure d'énergie (28) à vérifier, une plage de valeurs de mesure plus faible est ajustée et/ou une résolution de grandeur de mesure plus élevée est ajustée au niveau d'un moyen d'affichage (26) du dispositif de mesure d'énergie (28), par exemple Wh au lieu de kWh, que ce qui est ajusté dans le mode de veille de charge (IM) au niveau du dispositif de mesure d'énergie (28).

11. Procédé selon l'une des revendications précédentes, dans lequel, dans le mode de vérification de comptage d'énergie (CM), une source de lumière (59) du dispositif de mesure d'énergie (28) est évaluée, plus particulièrement une source de lumière (59) pour l'émission d'impulsions lumineuses, ces impulsions lumineuses constituant un équivalent à la quantité d'énergie électrique mesurée par le dispositif de mesure d'énergie (28).

12. Procédé selon la revendication 11, dans lequel la source lumineuse (59) du dispositif de mesure d'énergie (28) est désactivée, dans le mode de charge (LM) du dispositif de raccordement de charge (1), par le dispositif de commande (8) et elle est activée lors du passage dans le mode de vérification de comptage d'énergie (CM), plus particulièrement elle est commutée fonctionnellement par le dispositif de commande (8).

13. Procédé selon la revendication 11 ou 12, dans lequel l'appareil de contrôle d'étalonnage (36) compare la quantité d'énergie mise à disposition à partir de sa source de tension et de courant (37, 38) avec la quantité d'énergie mesurée par le dispositif de mesure d'énergie (28) dans le dispositif de raccordement de charge (1), plus particulièrement avec la quantité d'énergie à l'aide d'impulsions lumineuses par le dispositif de mesure d'énergie (28).

14. Procédé selon l'une des revendications précédentes, dans lequel la commutation dans le mode de vérification de comptage d'énergie (CM) est effectuée par la saisie d'un code d'autorisation valide dans le dispositif de commande (8) ou dans le dispositif de mesure d'énergie (28).

15. Dispositif de raccordement de charge pour véhicules électriques, ce dispositif de raccordement de charge (1) comprenant
- une interface d'entrée (10) pour l'introduction en énergie électrique provenant d'un réseau d'alimentation électrique fixe (M) dans le dispositif de raccordement de charge (1),
- une interface de charge (12, 13) pour la distribution contrôlée d'énergie électrique à un véhicule électrique (V),
- un élément de commutation de puissance (4) pour la transmission contrôlée d'énergie électrique à l'interface de charge (12, 13),
- au moins un dispositif de commande (8) pour la surveillance et la commande de processus fonctionnels au moins du dispositif de raccordement de charge (1) et
- un dispositif de mesure d'énergie (28), ce dispositif de mesure d'énergie (28) étant conçu pour la mesure et le comptage de la quantité d'énergie électrique consommée pendant les processus de charge des véhicules électriques,
dans lequel le dispositif de raccordement de charge (1) peut être mis, à l'aide d'une action consciente d'un opérateur, dans un mode de vérification de comptage d'énergie (CM) et dans lequel le dispositif de commande (8) du dispositif de raccordement de charge (1) est utilisé pour la commutation dans le mode de vérification de comptage d'énergie (CM) et le dispositif de commande (8) du dispositif de raccordement de charge (1) est conçu pour :
- faire passer un dispositif de communication de véhicule (34) ou une routine de communication du dispositif de raccordement de charge (1) par rapport à un véhicule (V) dans un état inactif de communication, par exemple à partir d'un état de veille de communication
- désactiver des fonctions de sécurité personnelles du dispositif de raccordement de charge (1),
- fermer ou maintenir fermé l'élément de commutation de puissance (4).

16. Dispositif de raccordement de charge selon la revendication 15, dans lequel le dispositif de commande (8) est en outre conçu pour exécuter, automatiquement après la fin d'un contrôle de la précision de mesure ou lors du déclenchement par un opérateur, les étapes suivantes :
- ouverture de l'élément de commutation de puissance (4),
- réactivation des fonctions de sécurité personnelles du dispositif de raccordement de charge (1),
- commutation du dispositif de raccordement de charge (1) du mode de vérification de comptage d'énergie (CM) vers le mode de veille de communication (IM) sur la base d'une action consciente d'un opérateur,
- passage du dispositif de communication de véhicule (34) ou de la routine de communication du dispositif de raccordement de charge (1) par rapport à un véhicule (V) de l'état inactif de communication vers l'état de veille de communication.

17. Dispositif de raccordement de charge selon la revendication 16, dans lequel le dispositif de commande (8) est conçu pour réactiver les fonctions de sécurité personnelles à l'aide d'une action manuelle d'un opérateur, par exemple à l'aide d'un actionnement d'un bouton (51).

18. Dispositif de raccordement de charge selon la revendication 16 ou 17, dans lequel le dispositif de commande (8) comprend un temporisateur (48) qui est conçu pour réactiver automatiquement les fonctions de sécurité personnelles après une durée de désactivation maximale prédéfinie, par exemple après 60 minutes.

19. Dispositif de raccordement de charge selon l'une des revendications 15 à 18, dans lequel, à l'intérieur d'un boîtier (3) du dispositif de raccordement de charge (1), est disposé au moins un élément de commutation (52) qui est conçu pour la commutation dans le mode de vérification de comptage d'énergie (CM) à l'aide d'un actionnement manuel par un opérateur.

20. Dispositif de raccordement de charge selon la revendication 19, dans lequel l'élément de commutation (52) comprend un premier et un deuxième élément de commutation à actionner manuellement.

21. Dispositif de raccordement de charge selon l'une des revendications 15 à 20, dans lequel le dispositif de commande (8) est conçu pour désactiver, dans le mode de vérification de comptage d'énergie (CM), en tant qu'une des fonctions de sécurité personnelles, un dispositif de surveillance d'élément de commutation de puissance (46) dans le dispositif de raccordement de charge (1).

22. Dispositif de raccordement de charge selon l'une des revendications 15 à 21, dans lequel le dispositif de commande (8) est conçu pour désactiver, dans le mode de vérification de comptage d'énergie (CM), en tant qu'une des fonctions de sécurité personnelles, un dispositif de surveillance de courant d'erreur (5, 45), plus particulièrement un dispositif d'arrêt d'erreur de courant continu, dans le dispositif de raccordement de charge (1).

23. Dispositif de raccordement de charge selon l'une des revendications 15 à 22, dans lequel le dispositif de commande (8) ou le dispositif de mesure d'énergie (28) est conçu pour prévoir, dans le mode de vérification de comptage d'énergie (CM), au niveau du dispositif de mesure d'énergie (28) à vérifier, une plage de valeurs de mesure plus faible et/ou une résolution de grandeur de mesure plus élevée au niveau d'un moyen d'affichage (26) du dispositif de mesure d'énergie (28), par exemple Wh au lieu de kWh, que dans le mode de veille de charge (IM) au niveau du dispositif de mesure d'énergie (28).

24. Dispositif de raccordement de charge selon l'une des revendications 15 à 23, dans lequel le dispositif de mesure d'énergie (28) comprend une source de lumière (59) et les impulsions lumineuses pouvant être émises par la source de lumière (59) constituent un équivalent à la quantité d'énergie électrique mesurée par le dispositif de mesure d'énergie (28).

25. Dispositif de raccordement de charge selon la revendication 24, dans lequel le dispositif de commande (8) ou le dispositif de mesure d'énergie (28) est conçu pour désactiver la source de lumière (59) du dispositif de mesure d'énergie (28) dans le mode de charge (LM) du dispositif de raccordement de charge (1) et pour le commuter fonctionnellement lors du passage dans le mode de vérification de comptage d'énergie (CM).

26. Dispositif de raccordement de charge selon l'une des revendications 15 à 25, dans lequel le dispositif de commande (8) est conçu pour passer dans le mode de vérification de comptage d'énergie (CM), par la saisie d'un code d'autorisation valide dans le dispositif de commande (8) ou dans le dispositif de mesure d'énergie (28).
